# EUROPEAN PATENT APPLICATION

(11) **EP 2 835 651 A1**
(43) Date of publication of application: **11.02.2015**
(21) Application number: 13772125.4
(22) Date of filing: 18.03.2013
(51) Int. Cl.: G01P 15/09, G01H 11/08, H01L 41/08, H01L 41/187

(54) **PIEZOELECTRIC VIBRATION SENSOR**

(30) Priority: 03.04.2012 JP 2012084670
(71) Applicant: NEC Corporation, Tokyo 108-8001 (JP)
(72) Inventor: TAKAHASHI, Masatake, Tokyo 108-8001 (JP); SHINODA, Shigeki, Tokyo 108-8001 (JP); TAKATA, Soichiro, Tokyo 108-8001 (JP); KASAI, Shigeru, Tokyo 108-8001 (JP); SASAKI, Yasuhiro, Tokyo 108-8001 (JP)
(74) Representative: Reeve, Nicholas Edward
(86) International application number: PCT/JP2013/001818
(87) International publication number: WO 2013/150731

(57) **Abstract**

A piezoelectric vibration sensor 100 includes a piezoelectric element 110 which is in a form of flat plate, an element holding plate 120 which is in a form of flat plate, and first and second support members 130a and 130b. An electrode is arranged on at least one plane of the piezoelectric element 110. The piezoelectric element 110 is joined to one plane of the piezoelectric element 110. The first support member 130a and the second support member 130b support the piezoelectric element 110 and the element holding plate 120. A vibration film 210 activates vibration of the element holding plate 120 between the first support member 130a and the second support member 130b. Moreover, the element holding plate 120 is joined to each of the first support member 130a and the second support member 130b through the vibration film 210. As a result, it is possible to obtain high sensitivity in a wide frequency range and to withstand an impact which is added from the outside.

## Description

### [Technical Field]

The present invention relates to a piezoelectric vibration sensor, and particularly relates to a piezoelectric vibration sensor in which a support member supports an element holding plate to which a piezoelectric element having a form of flat plate is joined.

### [Background Art]

In recent years, an electronic equipment, which is small and superior in portability, such as a cellular phone, a laptop personal computer, PDA (Personal Digital Assistant: portable information terminal), or the like is prevailing. Such electronic equipment is applied widely and enhances its function as a network system and software are progressed, and convenience on an user side is also improved remarkably.

As the electronic equipment is prevailing remarkably and the function of the electric equipment is enhanced as mentioned above, it is requested to enhance a function of an electronic device which is mounted inside the electronic equipment. A piezoelectric vibration sensor is also one of the electronic devices whose function is requested to be enhanced.

As an example of the piezoelectric vibration sensor which is related to the present invention, an acceleration sensor which has the cantilever structure is disclosed in a patent literature 1. The acceleration sensor includes a vibrator which vibrates in a lengthwise direction, and a support member which supports an end side of the vibrator. The vibrator has structure that a plurality of piezoelectric elements are joined to both planes of a vibration member which is in a form of strip of paper. The vibrator and the support member are integrated in a form of one member. The support member is firmly fixed to a printed wiring board or the like. Here, by adding acceleration to the vibration member of the vibrator in a direction vertical to a main plane of the vibration member, the vibration member together with the piezoelectric element bends, and consequently the piezoelectric element generates a voltage corresponding to the bend. Then, by measuring the voltage which the piezoelectric element generates, acceleration is calculated.

### [Citation List]

### [Patent Literature]

[PTL 1] Japanese Patent No. 3228089

### [Summary of Invention]

### [Technical Problem]

However, according to the art which is described in the patent literature 1, the vibration member of the vibrator and the support member are integrated in a form of one member. For this reason, there is a case that, even if external force is applied to the piezoelectric vibration sensor, sufficient moment is not generated at a boundary area of the vibration member and the support member, and consequently displacement in the direction vertical to the main plain of the vibration member is insufficient. As a result, there is a problem that it is impossible to obtain sufficient sensitivity at a low frequency area in particular.

Moreover, in the case that a large impact is added to the piezoelectric vibration sensor from the outside, the vibration member of the vibrator is displaced largely in the direction vertical to the main plane of the vibration member. At this time, there is a case that the vibration member comes into contact with the printed wiring board to which the support member of the piezoelectric vibration sensor is firmly fixed, a housing which stores the piezoelectric vibration sensor, or the like. For this reason, there is a problem that the vibration member of the vibrator is damaged and the piezoelectric vibration sensor is caused a fault.

As mentioned above, the art described in the patent literature 1 has the problem that there is a case that it is impossible to obtain the sufficient sensitivity at the lower frequency than the resonant frequency, and the problem that the fault is caused when receiving the severe impact from the outside.

The present invention is conceived in consideration of the above-mentioned circumstances. An object of the present invention is to provide a piezoelectric vibration sensor which can obtain high sensitivity in a wide frequency range, and withstand an impact from the outside.

### [Solution to Problem]

A piezoelectric vibration sensor according to the present invention includes: a piezoelectric element on whose at least one plane an electrode is arranged and which is in a form of flat plane; an element holding plate to whose one plate the piezoelectric element is joined and which is in a form of flat plate; a first support member and a second support member which support the piezoelectric element and the element holding plate; and a vibration film which activates vibration of the element holding plate between the first support member and the second support member, wherein the element holding plate is joined to each of the first support member and the second support member through the vibration film.

### [Advantageous Effects of Invention]

According to the piezoelectric vibration sensor of the present invention, it is possible to obtain high sensitivity in a wide frequency range, and to withstand an impact from the outside.

### [Brief Description of Drawings]

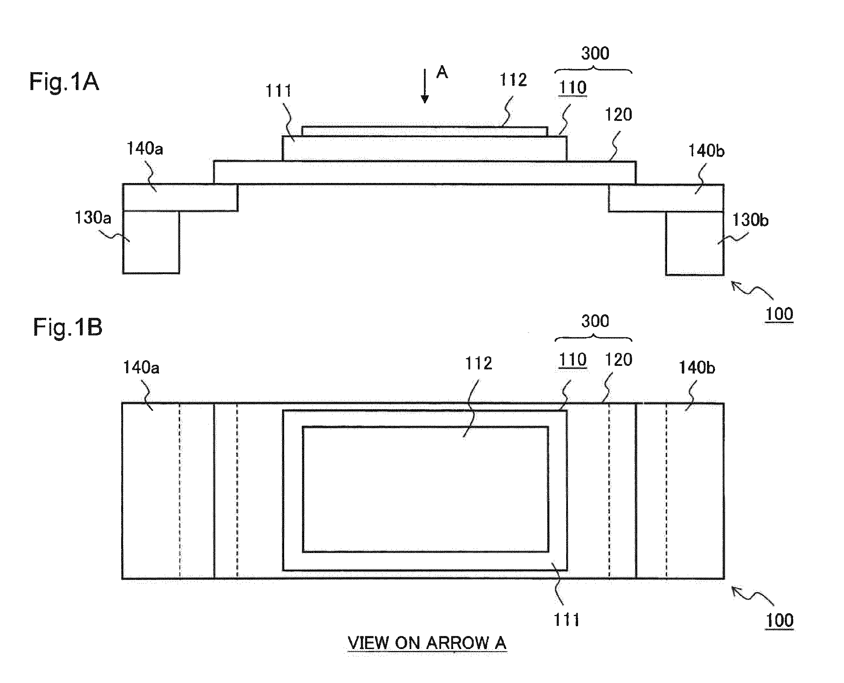

[Fig. 1A] Fig. 1A is a diagram which shows structure of a piezoelectric vibration sensor in a first exemplary embodiment of the present invention and which is a front view of the piezoelectric vibration sensor in the first exemplary embodiment of the present invention.
[Fig. 1B] Fig. 1B is a diagram which shows the structure of the piezoelectric vibration sensor in the first exemplary embodiment of the present invention and which is a top view of the piezoelectric vibration sensor in the first exemplary embodiment of the present invention.

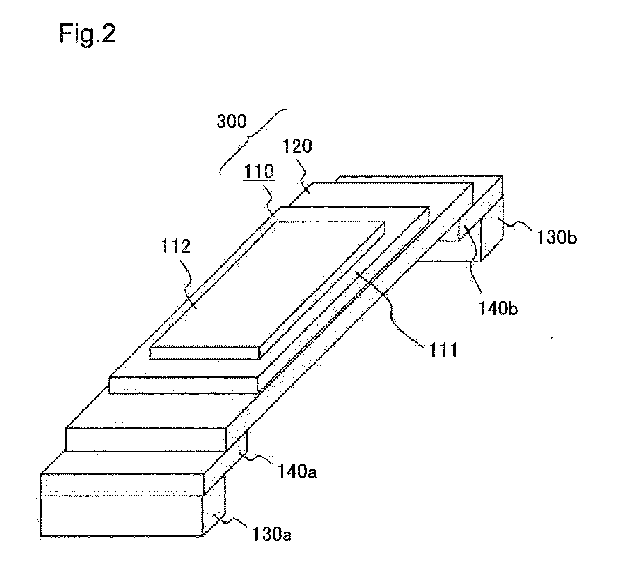

[Fig. 2] Fig. 2 is a perspective view showing the structure of the piezoelectric vibration sensor in the first exemplary embodiment of the present invention.

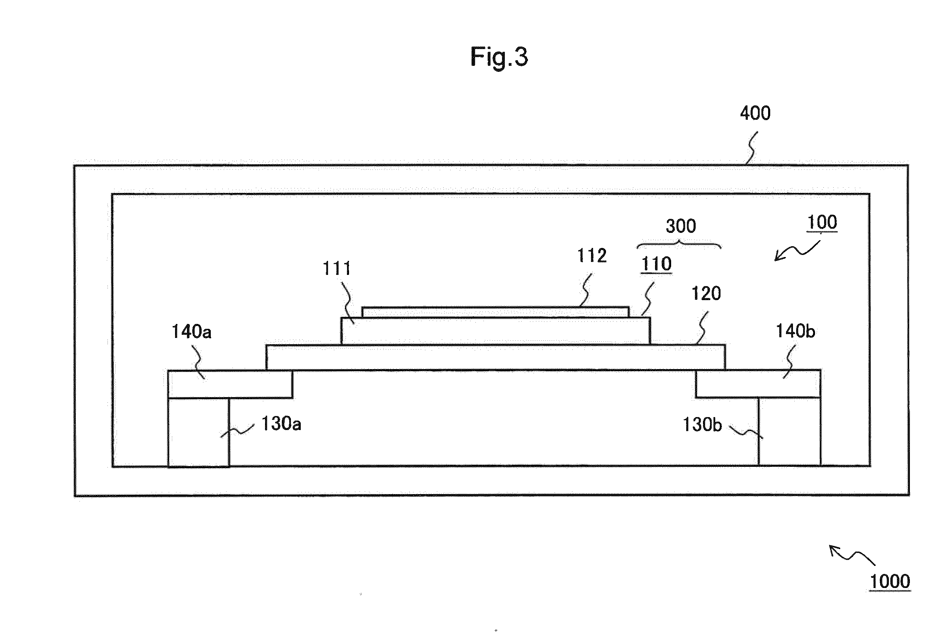

[Fig. 3] Fig. 3 is a schematic diagram showing schematically an electronic equipment in the first exemplary embodiment of the present invention.

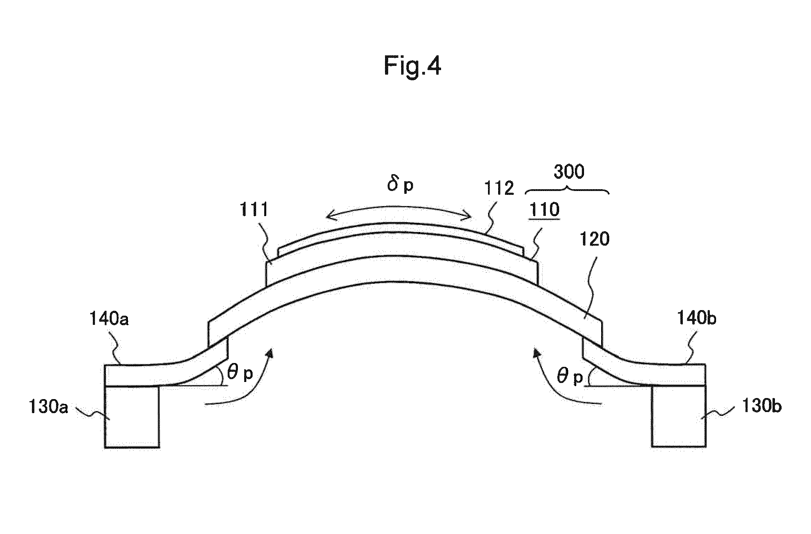

[Fig. 4] Fig. 4 is a diagram for explaining an operation of the piezoelectric vibration sensor in the first exemplary embodiment of the present invention.

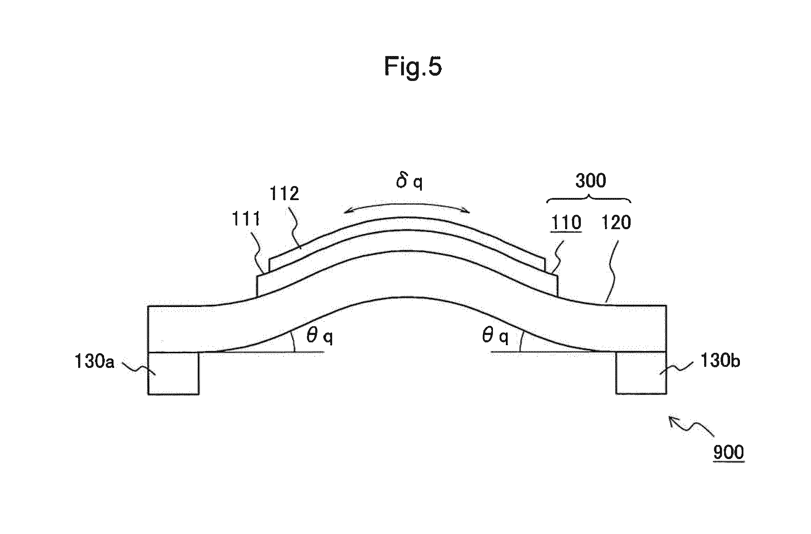

[Fig. 5] Fig. 5 is a diagram for explaining an operation of a related piezoelectric vibration sensor.

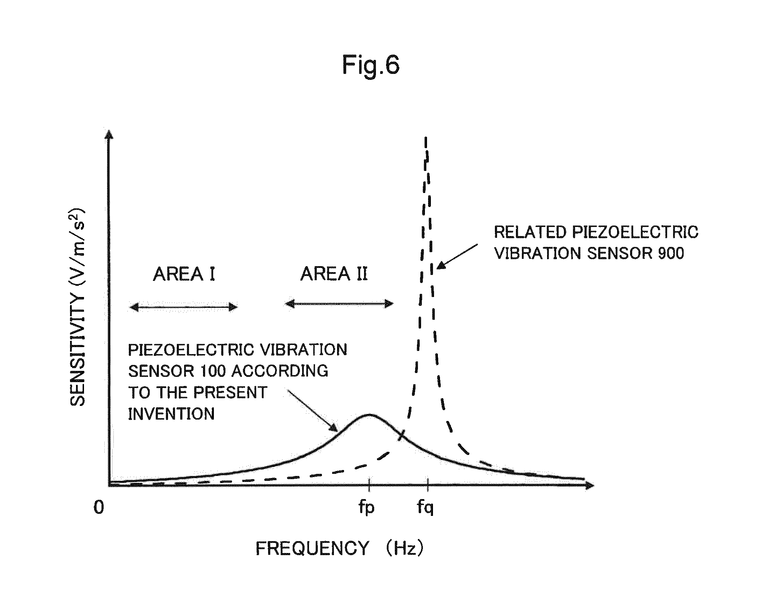

[Fig. 6] Fig. 6 is a diagram showing schematically a relation between sensitivity of the piezoelectric vibration sensor and each frequency in the first exemplary embodiment of the present invention, and a relation between sensibility of the related piezoelectric vibration sensor and each frequency.

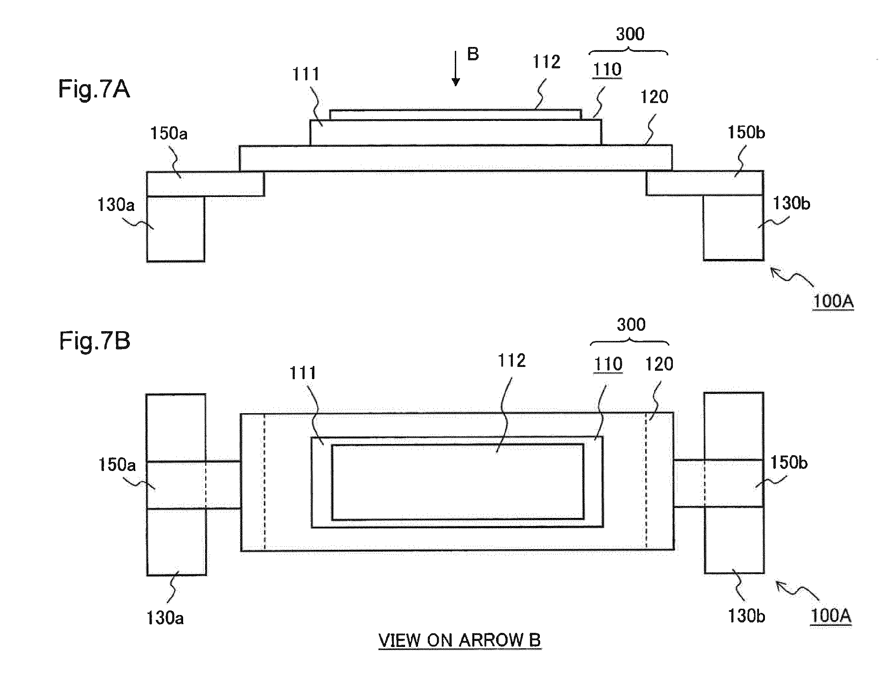

[Fig. 7A] Fig. 7A is a diagram which shows structure of a first modification of the piezoelectric vibration sensor in the first exemplary embodiment of the present invention, and which is a front view of the first modification of the piezoelectric vibration sensor in the first exemplary embodiment of the present invention.
[Fig. 7B] Fig. 7B is a diagram which shows the structure of the first modification of the piezoelectric vibration sensor in the first exemplary embodiment of the present invention, and which is a top view of the first modification of the piezoelectric vibration sensor in the first exemplary embodiment of the present invention.

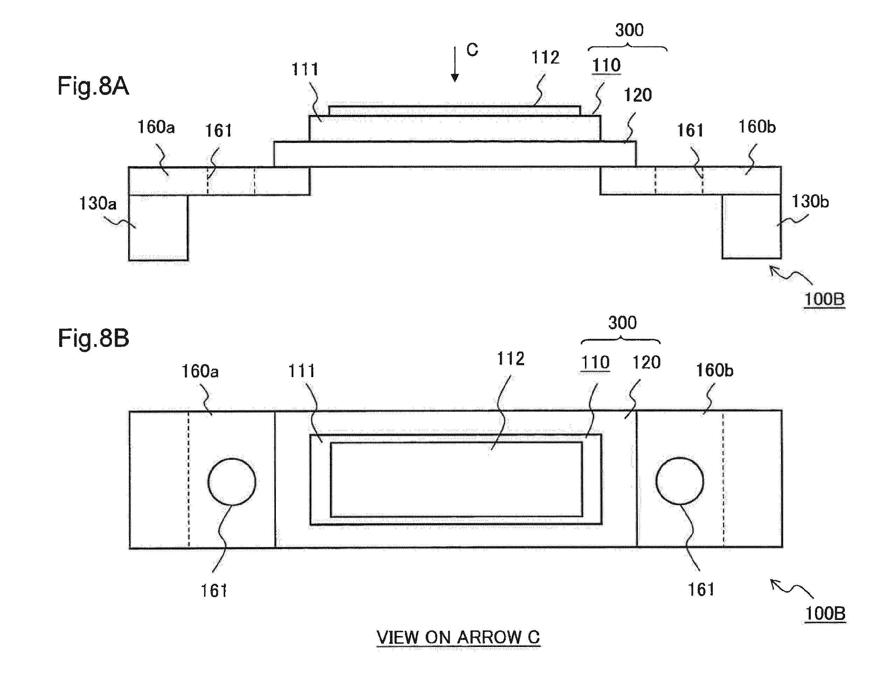

[Fig. 8A] Fig. 8A is a diagram which shows structure of a second modification of the piezoelectric vibration sensor in the first exemplary embodiment of the present invention, and which is a front view of the second modification of the piezoelectric vibration sensor in the first exemplary embodiment of the present invention.
[Fig. 8B] Fig. 8B is a diagram which shows the structure of the second modification of the piezoelectric vibration sensor in the first exemplary embodiment of the present invention, and which is a top view of the second modification of the piezoelectric vibration sensor in the first exemplary embodiment of the present invention.

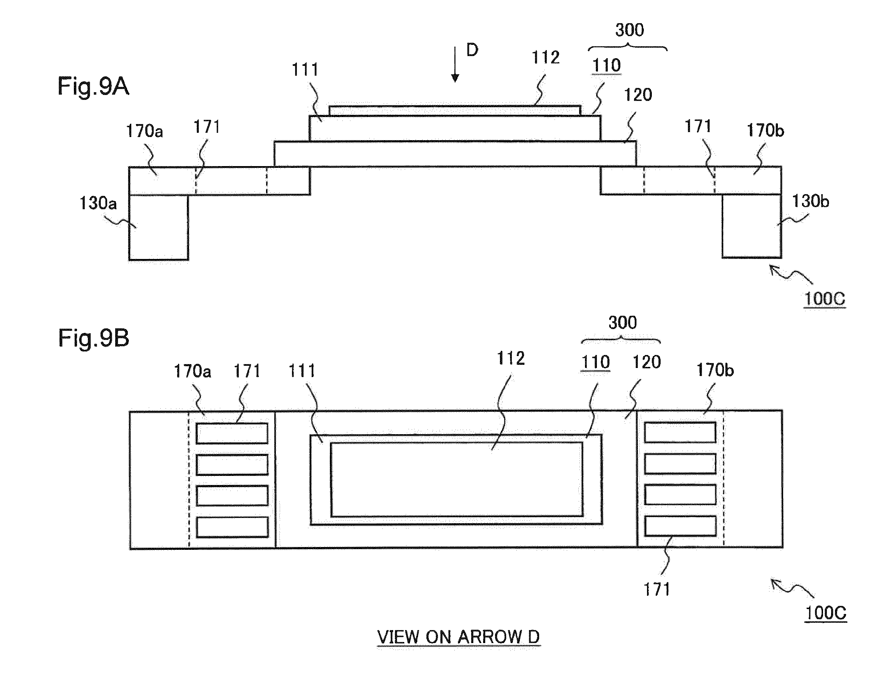

[Fig. 9A] Fig. 9A is a diagram which shows structure of a third modification of the piezoelectric vibration sensor in the first exemplary embodiment of the present invention, and which is a front view of the third modification of the piezoelectric vibration sensor in the first exemplary embodiment of the present invention.
[Fig. 9B] Fig. 9B is a diagram which shows the structure of the third modification of the piezoelectric vibration sensor in the first exemplary embodiment of the present invention, and which is a top view of the third modification of the piezoelectric vibration sensor in the first exemplary embodiment of the present invention.

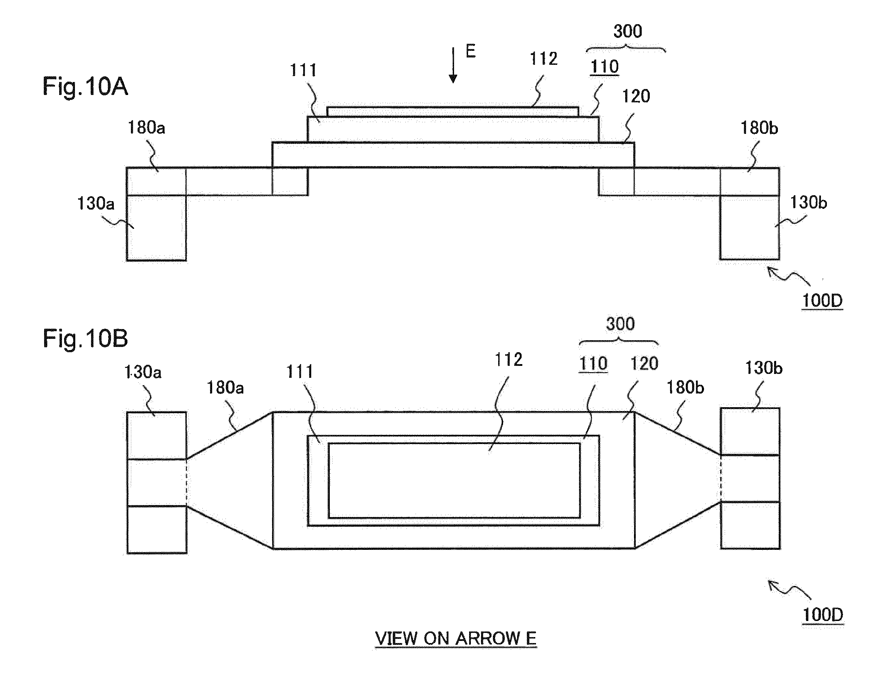

[Fig. 10A] Fig. 10A is a diagram which shows structure of a fourth modification of the piezoelectric vibration sensor in the first exemplary embodiment of the present invention, and which is a front view of the fourth modification of the piezoelectric vibration sensor in the first exemplary embodiment of the present invention.
[Fig. 10B] Fig. 10B is a diagram which shows the structure of the fourth modification of the piezoelectric vibration sensor in the first exemplary embodiment of the present invention, and which is a top view of the fourth modification of the piezoelectric vibration sensor in the first exemplary embodiment of the present invention.

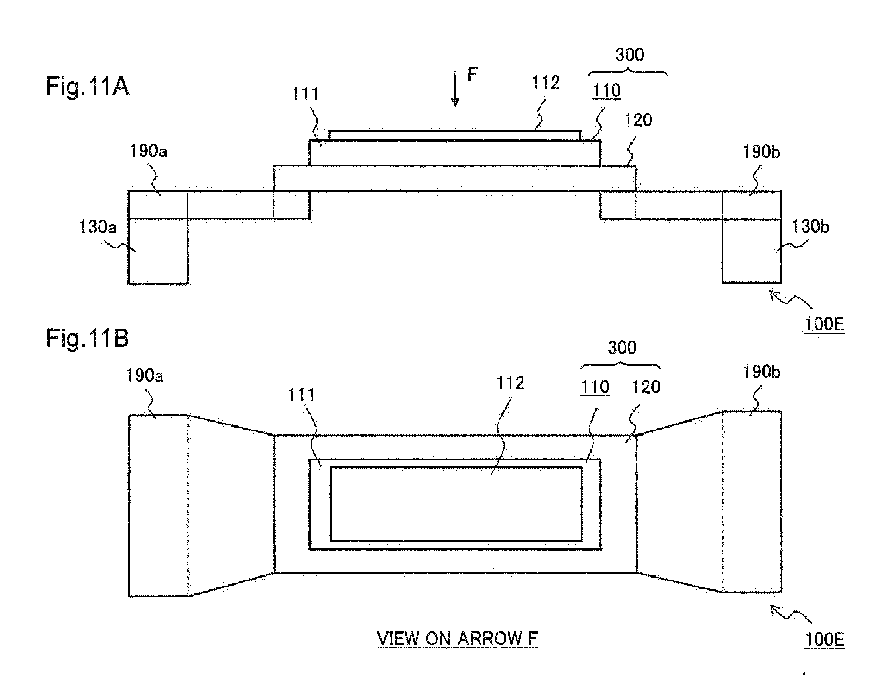

[Fig. 11A] Fig. 11A is a diagram which shows structure of a fifth modification of the piezoelectric vibration sensor in the first exemplary embodiment of the present invention, and which is a front view of the fifth modification of the piezoelectric vibration sensor in the first exemplary embodiment of the present invention.
[Fig. 11B] Fig. 11B is a diagram which shows the structure of the fifth modification of the piezoelectric vibration sensor in the first exemplary embodiment of the present invention, and which is a top view of the fifth modification of the piezoelectric vibration sensor in the first exemplary embodiment of the present invention.

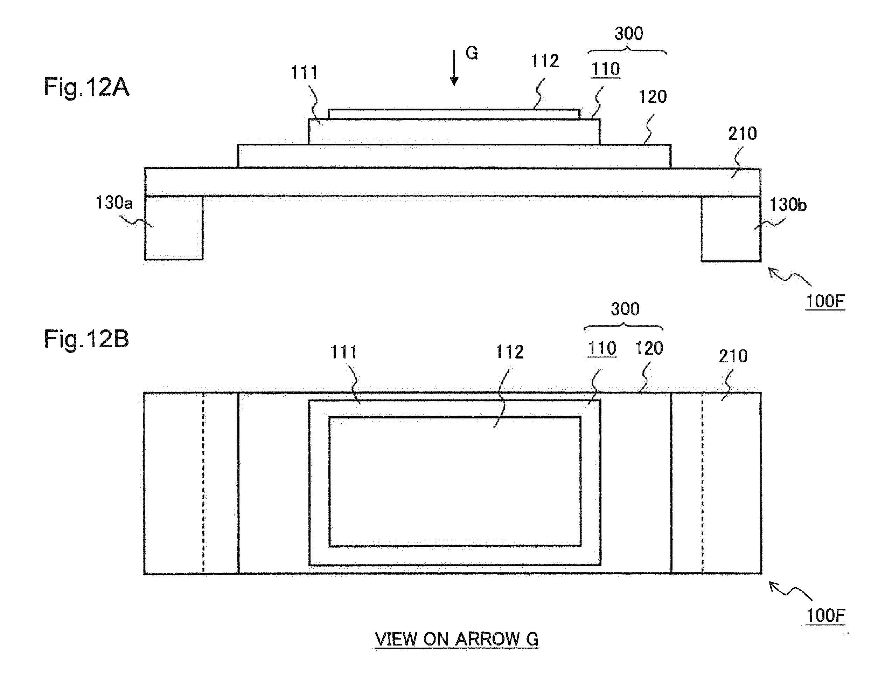

[Fig. 12A] Fig. 12A is a diagram which shows structure of a piezoelectric vibration sensor in a second exemplary embodiment of the present invention and which is a front view of the piezoelectric vibration sensor in the second exemplary embodiment of the present invention.
[Fig. 12B] Fig. 12B is a diagram which shows the structure of the piezoelectric vibration sensor in the second exemplary embodiment of the present invention and which is a top view of the piezoelectric vibration sensor in the second exemplary embodiment of the present invention.

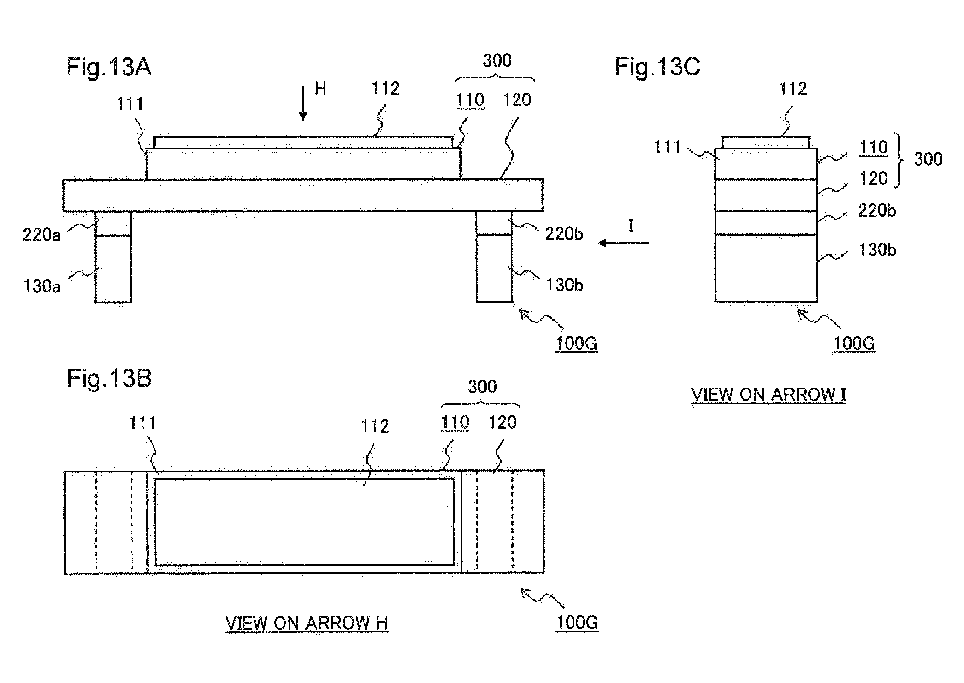

[Fig. 13A] Fig. 13A is a diagram which shows structure of a piezoelectric vibration sensor in a third exemplary embodiment of the present invention and which is a front view of the piezoelectric vibration sensor in the third exemplary embodiment of the present invention.
[Fig. 13B] Fig. 13B is a diagram which shows the structure of the piezoelectric vibration sensor in the third exemplary embodiment of the present invention and which is a top view of the piezoelectric vibration sensor in the third exemplary embodiment of the present invention.
[Fig. 13C] Fig. 13C is a diagram which shows the structure of the piezoelectric vibration sensor in the third exemplary embodiment of the present invention and which is a side view of the piezoelectric vibration sensor in the third exemplary embodiment of the present invention.

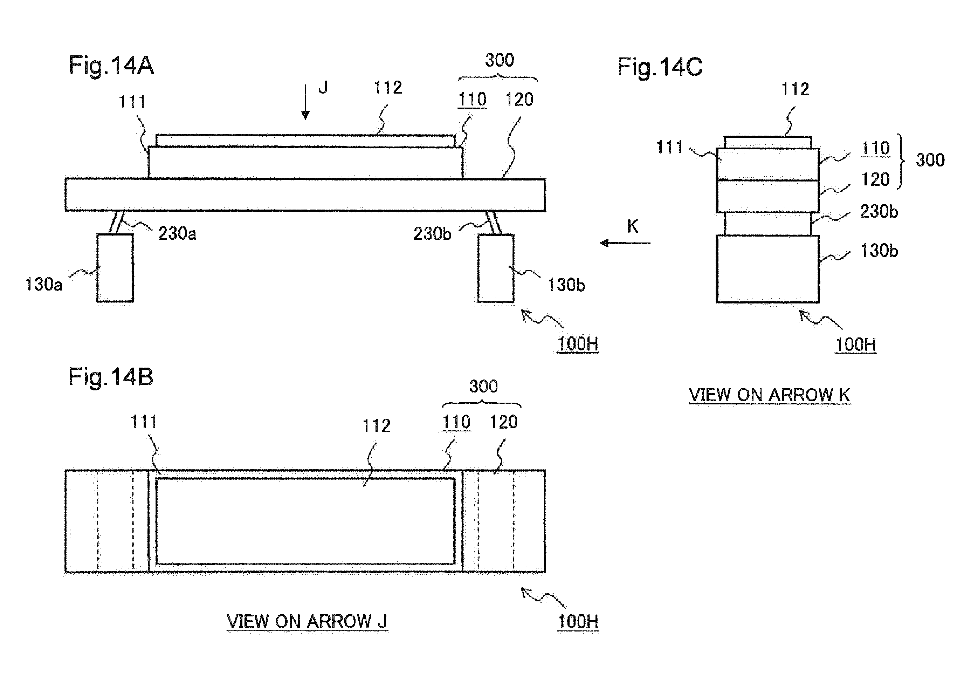

[Fig. 14A] Fig. 14A is a diagram which shows structure of a first modification of the piezoelectric vibration sensor in the third exemplary embodiment of the present invention, and which is a front view of the first modification of the piezoelectric vibration sensor in the third exemplary embodiment of the present invention.
[Fig. 14B] Fig. 14B is a diagram which shows the structure of the first modification of the piezoelectric vibration sensor in the third exemplary embodiment of the present invention, and which is a top view of the first modification of the piezoelectric vibration sensor in the third exemplary embodiment of the present invention.
[Fig. 14C] Fig. 14C is a diagram which shows the structure of the first modification of the piezoelectric vibration sensor in the third exemplary embodiment of the present invention, and which is a side view of the first modification of the piezoelectric vibration sensor in the third exemplary embodiment of the present invention.

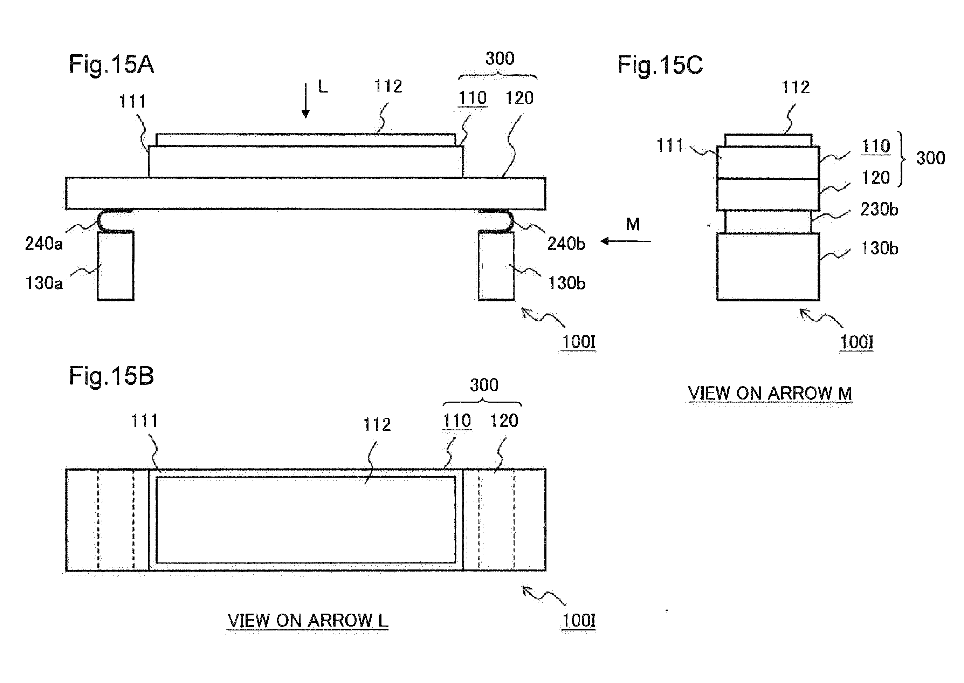

[Fig. 15A] Fig. 15A is a diagram which shows structure of a second modification of the piezoelectric vibration sensor in the third exemplary embodiment of the present invention, and which is a front view of the second modification of the piezoelectric vibration sensor in the third exemplary embodiment of the present invention.
[Fig. 15B] Fig. 15B is a diagram which shows the structure of the second modification of the piezoelectric vibration sensor in the third exemplary embodiment of the present invention, and which is a top view of the second modification of the piezoelectric vibration sensor in the third exemplary embodiment of the present invention.
[Fig. 15C] Fig. 15C is a diagram which shows the structure of the second modification of the piezoelectric vibration sensor in the third exemplary embodiment of the present invention, and which is a side view of the second modification of the piezoelectric vibration sensor in the third exemplary embodiment of the present invention.

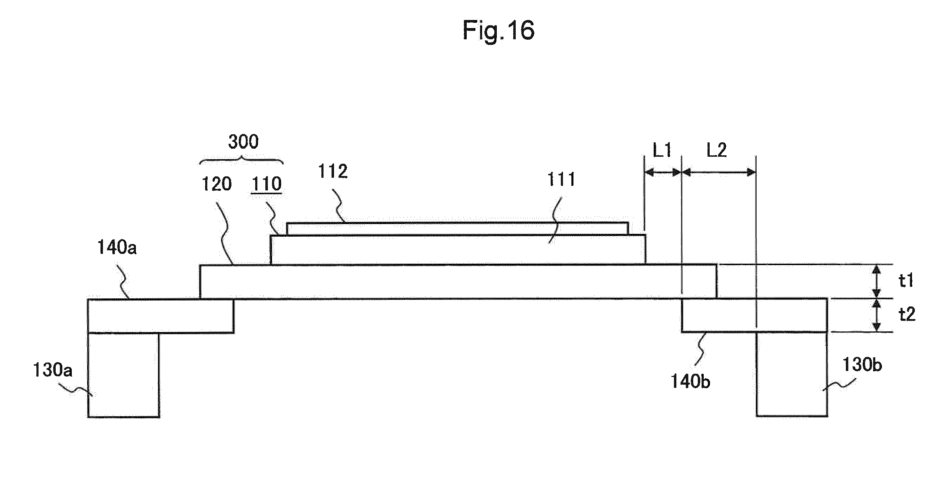

[Fig. 16] Fig. 16 is a diagram for explaining a size relation of an example of the piezoelectric vibration sensor in the first exemplary embodiment of the present invention.

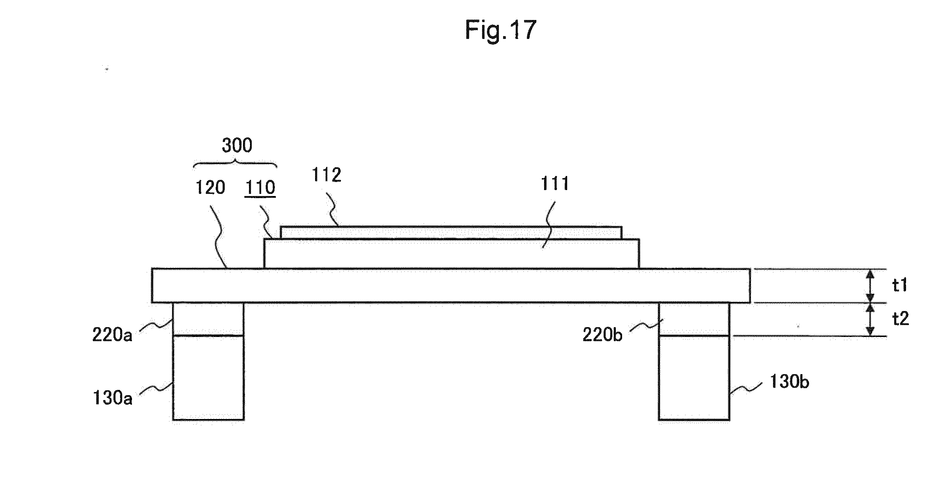

[Fig. 17] Fig. 17 is a diagram for explaining a size relation of an example of the piezoelectric vibration sensor in the third exemplary embodiment of the present invention.

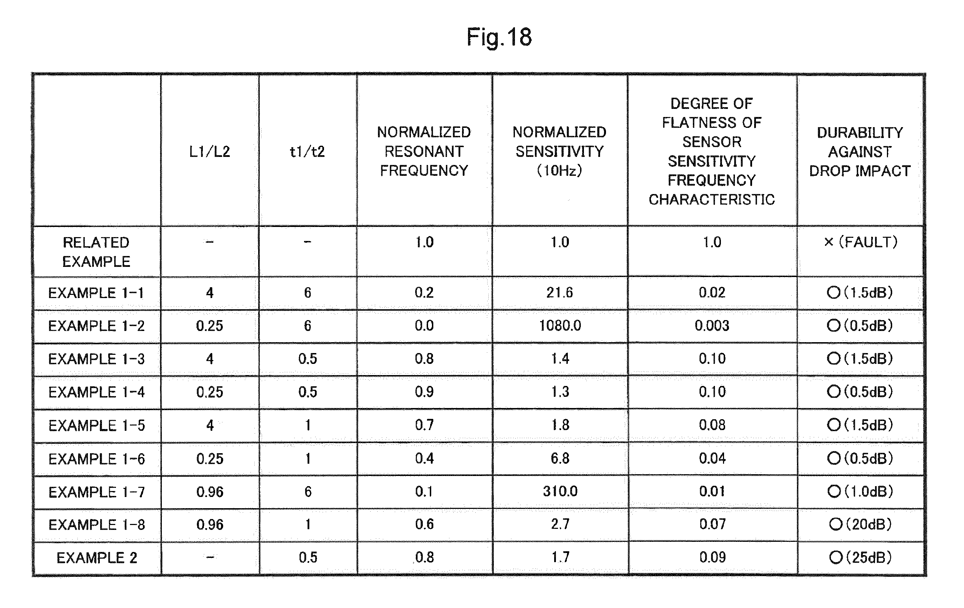

[Fig. 18] Fig. 18 is a diagram showing an evaluation result on the examples of the piezoelectric vibration sensor in the first and the third exemplary embodiments of the present invention.

### [Description of Embodiments]

### <First exemplary embodiment>

Structure of a piezoelectric vibration sensor 100 in a first exemplary embodiment of the present invention will be described with reference to a drawing.

Fig. 1A and Fig. 1B are diagrams each of which shows the structure of the piezoelectric vibration sensor 100. Fig. 1A is a front view of the piezoelectric vibration sensor 100. Fig. 1B is a diagram which shows a view on arrow A of Fig. 1A and which is a top view of the piezoelectric vibration sensor 100. Fig. 2 is a perspective view showing the structure of the piezoelectric vibration sensor 100.

As shown in Fig. 1A, Fig. 1B and Fig. 2, the piezoelectric vibration sensor 100 has structure which includes a piezoelectric element 110, an element holding plate 120, a first support member 130a, a second support member 130b, a first vibration film 140a and a second vibration film 140b. Here, integration of the piezoelectric element 110 and the element device holding plate 120 and the like compose a vibrator 300.

The piezoelectric element 110 has a form of flat plate, and an electrode 112 is arranged on at least one plane of the piezoelectric element 110. A base member 111 of the piezoelectric element 110 is made of, for example, ceramic or the like. As material of the electrode 112, for example, silver, copper, gold, alloy of these metals, or the like is used.. Fig. 1A and Fig. 1B show an example that the electrode 112 is formed on one plane of the base member 111. As mentioned above, the electrodes 112 may be formed on one plane of the base member 111, and another plane of the base member 111 which is opposite to the one plate.

The element holding plate 120 has a form of flat plate, and the piezoelectric element 110 is joined to one plane of the element holding plate 120. The element holding plate 120 has an elastic property. Moreover, as material of the element holding plate 120, metal such as, for example, 42 alloy, nickel, iron, chrome, phosphor bronze or the like, and nonmetal such as, for example, ceramic, quartz, crystal or the like can be used. Here, the element holding plate 120 is also called a shim. Fig. 1A and Fig. 1B show an example that the piezoelectric element 110 is joined to one plane of the element holding plate 120. The vibrator which has the structure mentioned above is called the vibrator which has the unimorph structure. Meanwhile, the piezoelectric elements 110 may be formed on one plane of the element holding plate 120 and another plane of the element holding plate 120 which is opposite to the one plane. Such vibrator is called the vibrator which has the bimorph structure.

The first support member 130a and the second support member 130b support the piezoelectric element 110 and the element holding plate 120. More specifically, the first support member 130a supports one end side of the element holding plate 120 to whose one plane the piezoelectric element 110 is joined through the first vibration film 140a which will be described later. Meanwhile, the second support member 130b supports the other end side of the element holding plate 120 to whose one plane the piezoelectric element 110 is joined through the second vibration film 140b which will be described later. Rigid material is applied to the first support member 130a and the second support member 130b.

As material of the first support member 130a and the second support member 130b, a metal casting item and a resin molding item of ABS resin (Acrylonitrile Butadiene Styrene copolymer synthetic resin) or the like can be used.

The first vibration film 140a and the second vibration film 140b have a function to activate vibration of the element holding plate 120 between the first support member 130a and the second support member 130b. Accordingly, as material of the first vibration film 140a and the second vibration film 140b, material whose rigidity is lower than one of the element holding plate 120 and which generates repulsive force against external force which is added can be used. As material of the first and the second vibration films, for example, polyethylene terephthalate (hereinafter, merely referred to as PET), polyurethane, or the like can be used.

The first vibration film 140a joins the first support member 130a and one end side of the element holding plate 120 together. The first vibration member 140a and the first support member 130a are joined by an adhesive or the like. The first vibration film 140a and the one end side of the element holding plate 120 are joined by an adhesive or the like.

The second vibration film 140b joins the second support member 130b and the other end side of the element holding plate 120 together. The second vibration film 140b and the second support member 130b are joined by an adhesive or the like. The second vibration film 140b and the other end side of the element holding plate 120 are joined by an adhesive or the like.

That is, both end sides of the element holding plate 120 are joined to the first support member 130a and the second support member 130b through the first vibration film 140a and the second vibration film 140b respectively.

Next, structure of an electronic equipment 1000, which is equipped with the piezoelectric vibration sensor 100, will be described with reference to a drawing.

Fig. 3 is a schematic diagram showing the structure of the electronic equipment 1000 schematically. As shown in Fig. 3, the electronic equipment 1000 has structure which includes the piezoelectric vibration sensor 100 and a housing 400. The structure of the piezoelectric vibration sensor 100 is the same as the structure which has been described with reference to Fig. 1A, Fig. 1B and Fig. 2. As shown in Fig. 3, the housing 400 stores the piezoelectric vibration sensor 100. Moreover, the housing 400 stores not only the piezoelectric vibration sensor 100 but also various electronic components (not shown in the figure). Here, as material of the housing 400, for example, a metal casting item or a metal plate made of stainless steel, aluminum, magnesium or the like, and a resin molding item made of ABS resin, polycarbonate resin or the like can be used.

As shown in Fig. 3, the first support member 130a and the second support member 130b of the piezoelectric vibration sensor 100 are fixed to the housing 400 by an adhesive or the like. Here, while not shown in the figure, the first support member 130a and the second support member 130b may be fixed to a holding member (for example, electronic board) which is fixed to the housing 400.

Next, an operation of the piezoelectric vibration sensor 100 will be described in the following with reference to a drawing. Here, the operation of the piezoelectric vibration sensor 100 according to the present invention will be described in comparison with an operation of a piezoelectric vibration sensor 900 which is related to the present invention.

Fig. 4 is a diagram for explaining the operation of the piezoelectric vibration sensor 100, and indicates a state that the element holding plate 120, to which the piezoelectric element 110 is joined, bends in a direction leaving from the first support member 130a and the second support member 130b.

Fig. 5 is a diagram for explaining the operation of the piezoelectric vibration sensor 900, and indicates a state that the element holding plate 120, to which the piezoelectric element 100 is joined, bends in a direction leaving from the first support member 130a and the second support member 130b.

As shown in Fig. 5, the general piezoelectric vibration sensor 900 does not include the first vibration film 140a and the second vibration film 140b in comparison with the piezoelectric vibration sensor 100 of the present invention. That is, in the case of the piezoelectric vibration sensor 900, the element holding plate 120, to which the piezoelectric element 110 is joined, is joined directly to the first support member 130a and the second support member 130b.

Fig. 6 is a diagram showing schematically a relation between sensitivity of the piezoelectric vibration sensor 100 and each frequency in the first exemplary embodiment, and a relation between sensibility of the related piezoelectric vibration sensor 900 and each frequency.

In Fig. 6, the vertical axis indicates the sensitivity (V/ [m/s2]) of the piezoelectric vibration sensor 100 and the piezoelectric vibration sensor 900, and the horizontal axis indicates frequency (Hz). Here, the sensitivity of the piezoelectric vibration sensor 100 and the piezoelectric vibration sensor 900 is defined as a sensor output voltage per vibration acceleration 1m/s² (V/ [m/s²])

As shown in Fig. 6, the sensitivity of the related piezoelectric vibration sensor 900 becomes large remarkably in the vicinity of a mechanical resonant frequency fq of the piezoelectric vibration sensor 900. That is, in the case of the piezoelectric vibration sensor 900, mechanical resonance is generated by coincidence of the mechanical resonant frequency fq which is determined by the piezoelectric element 110, the element holding plate 120, the first support member 130a and the second support member 130b, and a vibration frequency of a measurement target. Since the element holding plate 120 is deformed largely by the resonance, the sensitivity of the piezoelectric vibration sensor 900 also becomes large remarkably.

In the case that the piezoelectric vibration sensor 900 is used in a state that the sensitivity is large remarkably as mentioned above, there is a fear that the piezoelectric vibration sensor 900 may be caused damaged. For this reason, in the case of using the general piezoelectric vibration sensor 900, it is requested to avoid a frequency area near to the mechanical resonant frequency fq, and to use the general piezoelectric vibration sensor 900 in a frequency area whose frequency is sufficiently lower than the mechanical resonant frequency fq.

In contrast, while the sensitivity of the piezoelectric vibration sensor 100 of the present invention is not so larger than the sensitivity of the piezoelectric vibration sensor 900 in the vicinity of a mechanical resonant frequency fp of the piezoelectric vibration sensor 100 as shown in Fig. 6, a frequency area in which the sensitivity of the piezoelectric vibration sensor 100 is higher than the sensitivity of the piezoelectric vibration sensor 900 expands widely.

Here, in comparison with the operation of the related piezoelectric vibration sensor 900, the operation of the piezoelectric vibration sensor 100, which is carried out in the case that the vibration frequency of the measurement target is sufficiently lower than the mechanical resonant frequency fq of the piezoelectric vibration sensor 900 (area I in Fig. 6), and in the case that the vibration frequency of the measurement target is close to the mechanical resonant frequency fq of the piezoelectric vibration sensor 900 (area II in Fig. 6).

Firstly, the area I will be described in the following.

As shown in Fig. 5, in the case of the general piezoelectric vibration sensor 900, the element holding plate 120, to which the piezoelectric element 110 is joined, is joined directly to the first support member 130a and the second support member 130b. For this reason, in the vicinity of a joint area of the element holding plate 120 and the first support member 130a, the element holding plate 120 cannot rotate freely, and a bend angle θ q is also small as shown in Fig. 5. Similarly, in the vicinity of a joint area of the element holding plate 120 and the second support member 130b, the element holding plate 120 cannot rotate freely, and a bend angle θ q is also small.

As a result, an amount of displacement δ q in a direction of a plane of the piezoelectric element 112 also becomes small. For this reason, the piezoelectric vibration sensor 900 cannot obtain the high sensitivity in the area I.

On the other hand, in the case of the piezoelectric vibration sensor 100 of the present invention, both end sides of the element holding plates 120 are joined to the first support member 130a and the second support member 130b through the first vibration film 140a and the second vibration film 140b respectively as mentioned above. Moreover, the first vibration film 140a and the second vibration film 140b are made of material whose rigidity is small in comparison with the element holding plate 120, and have a function to activate vibration of the element holding plate 120 between the first support member 130a and the second support member 130b.

Accordingly, in the vicinity of a joint area of the first vibration film 140a and the first support member 130a, the element holding plate 120 can rotate freely, and furthermore a bend angle θ p is large in comparison with the piezoelectric vibration sensor 900 as shown in Fig. 4 . Similarly, in the vicinity of a joint area of the second vibration film 140b and the second support member 130b, the element holding plate 120 can rotate freely, and furthermore a bend angle θ p is large in comparison with the piezoelectric vibration sensor 900. As mentioned above, by setting up the structure which can make both end sides of the element holding plate 120 rotate freely, a bending movement of the element holding plate 120 is activated.

As a result, an amount of displacement δ p in the direction of the plane of the piezoelectric element 112 also becomes large in comparison with the piezoelectric vibration sensor 900. Accordingly, as shown in Fig. 6, the piezoelectric vibration sensor 100 can obtain the high sensitivity in comparison with the piezoelectric vibration sensor 900.

Next, an area II will be described in the following.

As shown in Fig. 6, the sensitivity of the related piezoelectric vibration sensor 900 has a sharp peak in the vicinity of the mechanical resonant frequency fq of the piezoelectric vibration sensor 900. The above mention means that, since vibration damping property of the structure which includes the piezoelectric element 110 and the element holding plate 120 becomes small, the piezoelectric element 110 and the element holding plate 120 are deformed largely. In other words, the above mention means that, since a degree of resonance sharpness Q which indicates an amplification factor of the vibration become large, the piezoelectric element 110 and the element holding plate 120 are deformed largely.

On the other hand, in the case of the piezoelectric vibration sensor 100 of the present invention, since the element holding plates 120 is joined to the first support member 130a and the second support member 130b through the first vibration film 140a and the second vibration film 140b respectively as mentioned above, a degree of resonance sharpness Q is small in comparison with the piezoelectric vibration sensor 900. The reason is that the first vibration film 140a and the second vibration film 140b are made of material whose rigidity is small in comparison with the element holding plate 120, and consequently have an ability to damp the vibration.

In the case that the element holding plate 120 carries out the bending movement, deformation stress of the element holding plate 120 usually concentrates on the vicinity of a support point (joint area of the first support member 130a and the first vibration film 140a, and joint area of the second support member 130b and the second vibration film 140b). The large deformation of the element holding plate 120, which is caused at the support point when the mechanical resonance is generated, is restrained by the vibration damping ability which the first vibration film 140a and the second vibration film 140b have.

For this reason, a degree of resonance sharpness Q of the piezoelectric vibration sensor 100 consequently becomes small in comparison with the piezoelectric vibration sensor 900. Furthermore, as shown in Fig. 6, the sensitivity of the piezoelectric vibration sensor 100 does not change abruptly in the vicinity of the mechanical resonant frequency fp. The above mention means that the piezoelectric vibration sensor 100 can be used in a wide frequency range in comparison with the piezoelectric vibration sensor 900.

Here, a case that a drop impact is added to each of the piezoelectric vibration sensor 100 and the piezoelectric vibration sensor 900 will be considered in the following. In this case, vibration is added to the piezoelectric vibration sensor 100 and the piezoelectric vibration sensor 900 in a wide frequency range.

In the case that the drop impact is added to the piezoelectric vibration sensor 900, the mechanical resonance, whose degree of resonance sharpness Q is large, is excited, and consequently the piezoelectric element 110 and the element holding plate 120 are deformed largely. For this reason, a fear that the piezoelectric element 110 and the element holding plate 120 may come into contact with an inner wall of the housing (not shown in Fig. 5), which stores the piezoelectric vibration sensor 900, or the like is caused. As a result, there is a fear that the piezoelectric vibration sensor 900 may be caused a fault.

In the case of the piezoelectric vibration sensor 900, the element holding plate 120 is joined directly to the first and second support members 130a and 130b. For this reason, in the case that the drop impact is added to the piezoelectric vibration sensor 900, there are a lot of possibilities that deformation stress, which concentrates on a support point (joint area of the element holding plate 120 and the first support member 130a, and joint area of the element holding member 120 and the second support member 130b), is not damped and propagated to the piezoelectric element 110. Accordingly, there are a lot of possibilities that the piezoelectric vibration sensor 900 results in being damaged when adding the drop impact to the piezoelectric element 900.

On the other hand, in the case that the drop impact is added to the piezoelectric vibration sensor 100, a degree of resonance sharpness Q of the mechanical resonance becomes small by the vibration damping ability which the first vibration film 140a and the second vibration film 140b have. For this reason, it is restrained that the piezoelectric elements 110 and the element holding plate 120 come into contact with the inner wall of the housing 400, which stores the piezoelectric vibration sensor 100, or the like. As a result, a fear that the piezoelectric vibration sensor 100 may be caused a fault becomes low remarkably.

In the case of the piezoelectric vibration sensor 100, the element holding plate 120 is joined to the first support member 130a and the second support member 130b through the first vibration film 140a and the second vibration film 140b respectively. For this reason, in the case that the drop impact is added to the piezoelectric vibration sensor 100, an amount of deformation stress, which is propagated to the piezoelectric element 110 and the element holding plate 120, out of the deformation stress which concentrates on the support point (joint area of the first vibration film 140a and the first support member 130a, and joint area of the second vibration film 140b and the second support member 130b) is small in comparison with the piezoelectric vibration sensor 900. Accordingly, it is prevented that the piezoelectric vibration sensor 100 results in being damaged when adding the drop impact to the piezoelectric element 100.

As mentioned above, in the case of the piezoelectric vibration sensor 100 according to the present invention, it is possible to obtain the high sensitivity in a wide frequency range (corresponding to both of the area I and the area II shown in Fig. 6), and it is also possible to withstand the impact which is added from the outside.

As mentioned above, the piezoelectric vibration sensor 100 in the first exemplary embodiment of the present invention include the piezoelectric element 110, the element holding plate 120, the first support member 130a, the second support member 130b, the first vibration film 140a and the second vibration film 140b.

The piezoelectric element 110 has a form of flat plate, and the electrode 112 is arranged on at least one plane of the piezoelectric element 110. The element holding plate 120 has a form of flat plate, and the piezoelectric element 110 is arranged on one plane of the element holding plate 120. The first support member 130a and the second support member 130b support the piezoelectric element 110 and the element holding plate 120. The vibration film (first vibration film 140a and second vibration film 140b) has the function to activate the vibration of the element holding plate 120 between the first support member 130a and the second support member 130b. Moreover, the element holding plate 120 is joined to each of the first support member 130a and the second support member 130b through the vibration film (first vibration film 140a and second vibration film 140b).

As mentioned above, the element holding plate 120 is joined to the first support member 130a and the second support member 130b through the first vibration film 140a and the second vibration film 140b respectively. Moreover, the first vibration film 140a and the second vibration film 140b are made of material whose rigidity is small in comparison with the element holding plate 120, and have the function to activate the vibration of the element holding plate 120 between the first support member 130a and the second support member 130b.

The operation of the piezoelectric vibration sensor 100, which is carried out in the case that the vibration frequency of the measurement target is sufficiently smaller than the mechanical resonant frequency fq of the piezoelectric vibration sensor 900 (area I in Fig. 6), is shown in the following. That is, in the vicinity of the joint area of the first vibration film 140a and the first support member 130a, the element holding plate 120 can rotate freely in comparison with the piezoelectric vibration sensor 900. Similarly, in the vicinity of the joint area of the second vibration film 140b and the second support member 130b, the element holding plate 120 can rotate freely. As mentioned above, by the structure which can make both end sides of the element holding plate 120 rotate freely, the bending movement of the element holding plate 120 is activated. As a result, an amount of displacement in the direction of the plane of the piezoelectric element 112 also becomes large in comparison with the piezoelectric vibration sensor 900.

Moreover, the operation of the piezoelectric vibration sensor 100, which is carried out in the case that the vibration frequency of the measurement target is close to the mechanical resonant frequency fq of the piezoelectric vibration sensor 900 (area II in Fig. 6), is shown in the following. That is, in the case of the piezoelectric vibration sensor 100 of the present invention, since the element holding plate 120 is joined to the first support member 130a and the second support member 130b through the first vibration film 140a and the second vibration film 140b respectively, a degree of resonance sharpness Q is small in comparison with the piezoelectric vibration sensor 900, The reason is that the first vibration film 140a and the second vibration film 140b are made of material whose rigidity is small in comparison with the element holding plate 120, and consequently have the ability to damp the vibration. In the case that the element holding plate 120 carries out the bending movement, the deformation stress of the element holding plate 120 usually concentrates on the vicinity of the support point (joint area of the first support member 130a and the first vibration film 140a, and joint area of the second support member 130b and the second vibration film 140b). The large deformation of the element holding plate 120, which is caused at the support point when the mechanical resonance is generated, is restrained by the vibration damping ability which the first vibration film 140a and the second vibration film 140b have. For this reason, as a result, a degree of resonance sharpness Q of the piezoelectric vibration sensor 100 becomes small in comparison with the piezoelectric vibration sensor 900. Furthermore, the sensitivity of the piezoelectric vibration sensor 100 does not change abruptly in the vicinity of the mechanical resonant frequency fp. The above mention means that the piezoelectric vibration sensor 100 can be used in a wide frequency range in comparison with the piezoelectric vibration sensor 900.

Moreover, in the case that the drop impact is added to the piezoelectric vibration sensor 100, a degree of resonance sharpness Q of the mechanical resonance becomes small by the vibration damping ability which the first vibration film 140a and the second vibration film 140b have. For this reason, it is restrained that the piezoelectric element 110 and the element holding plate 120 come into contact with the inner wall of the housing (not shown in the figure), which stores the piezoelectric vibration sensor 100, or the like. As a result, a fear that the piezoelectric vibration sensor 100 is caused a fault becomes low remarkably. In the case of the piezoelectric vibration sensor 100, the element holding plate 120 is joined to the first support member 130a and the second support member 130b through the first vibration film 140a and the second vibration film 140b respectively. For this reason, in the case that the drop impact is added to the piezoelectric vibration sensor 100, an amount of deformation stress, which is propagated to the piezoelectric element 110 and the element holding plate 120, out of the deformation stress which concentrates on the support point (joint area of the first vibration film 140a and the first support member 130a, and joint area of the second vibration film 140b and the second support member 130b) is small in comparison with the piezoelectric vibration sensor 900. Accordingly, it is prevented that the piezoelectric vibration sensor 100 results in being damaged when the drop impact is added to the piezoelectric element 100.

By virtue of the above, according to the piezoelectric vibration sensor 100 in the first exemplary embodiment of the present invention, it is possible to obtain the high sensitivity in a wide frequency range, and to withstand the impact which is added from the outside.

Moreover, in the case of the piezoelectric vibration sensor 100 in the first exemplary embodiment of the present invention, the vibration film includes the first vibration film 140a and the second vibration film 140b. The first vibration film 140a joins the element holding plate 120 and the first support member 130a together. Moreover, the second vibration film 140b joins the element holding plate 130b and the second support member 130b together.

As mentioned above, it is also possible to divide the vibration film into two parts correspondingly to the first support member 130a and the second support member 130b.

Moreover, in the case of the piezoelectric vibration sensor 100 in the first exemplary embodiment of the present invention, the vibration film (first vibration film 140a and second vibration film 140b) extends in a direction of one plane of the element holding plate 120. As a result, it is possible to restrain a height of the piezoelectric vibration sensor 100 so as to be low.

Moreover, in the case of the piezoelectric vibration sensor 100 in the first exemplary embodiment of the present invention, the vibration film (first vibration film 140a and second vibration film 140b) is made of polyethylene terephthalate. As a result, it is possible to make the vibration film made of simple material.

Moreover, in the case of the piezoelectric vibration sensor 100 in the first exemplary embodiment of the present invention, the piezoelectric element 110 may be joined to both of one plane of the element holding plate 120 and another plane of the element holding plate 120 which is opposite to the one plane. By virtue of the above, an effect which is equivalent to the above-mentioned effect is provided.

Moreover, the electronic equipment 1000 in the first exemplary embodiment of the present invention is equipped with the piezoelectric vibration sensor 100 mentioned above. As mentioned above, the piezoelectric vibration sensor 100 can be used as a part of the electronic apparatus 1000. By virtue of the above, it is possible to provide an effect which is equivalent to the above-mentioned effect provided by the piezoelectric vibration sensor 100.

### [First modification]

Next, a first modification 100A of the piezoelectric vibration sensor in the first exemplary embodiment of the present invention will be described on the basis of a drawing.

Fig. 7A and Fig. 7B are diagrams each of which shows structure of the piezoelectric vibration sensor 100A. Fig. 7A is a front view of the piezoelectric vibration sensor 100A. Fig. 7B is a diagram which shows a view on arrow B of Fig. 7A and which is a top view of the piezoelectric vibration sensor 100A. Here, a component shown in Figs. 7A and 7B, which is equivalent to a component shown in Fig. 1 to Fig. 6, is assigned the same code as the component shown in Fig 1 to Fig. 6 has.

As shown in Fig. 7A and Fig. 7B, the piezoelectric vibration sensor 100A has structure which includes the piezoelectric element 110, the element holding plate 120, the first support member 130a, the second support member 130b, a first vibration film 150a and a second vibration film 150b.

Here, Fig. 7A and Fig. 7B are compared with Fig. 1A and Fig. 1B. A width (width means a length of the vibration film in an upward and downward direction on papers of Fig. 1B and Fig. 7B.) of the first vibration film 150a and the second vibration film 150b shown in Fig. 7B is narrow in comparison with the first vibration film 140a and the second vibration film 140b shown in Fig. 1B.

Assuming that a cross section is a rectangle which has a width b and a height h, cross-section secondary moment I is expressed in I = (bh³)/12.

Accordingly, cross-section secondary moment of the first vibration film 150a and the second vibration film 150b shown in Fig. 7A and Fig. 7B becomes smaller than one of the first vibration film 140a and the second vibration film 140b shown in Fig. 1A and Fig. 1B.

It is generally known that a bend angle of a beam and an amount of bend become large as the cross-section secondary moment is small. For this reason, in the case of the piezoelectric vibration sensor 100A, bend angles at a joint area of the first support member 130a and the first vibration film 150a, and a joint area of the second support member 130b and the second vibration film 150b become large, and an amount of bend at a central part of the element holding plate 120 become large in comparison with the piezoelectric vibration sensor 100. As a result, according to the piezoelectric vibration sensor 100A, it is possible to obtain the high sensitivity in comparison with the piezoelectric vibration sensor 100.

### [Second modification]

Next, a second modification 100B of the piezoelectric vibration sensor in the first exemplary embodiment of the present invention will be described on the basis of a drawing.

Fig. 8A and Fig. 8B are diagrams each of which shows structure of the piezoelectric vibration sensor 100B. Fig. 8A is a front view of the piezoelectric vibration sensor 100B. Fig. 8B is a diagram which shows a view on arrow C of Fig. 8A and which is a top view of the piezoelectric vibration sensor 100B. Here, a component shown in Fig. 8A and Fig. 8B, which is equivalent to a component shown in Fig. 1 to Fig. 7, is assigned the same code as the component shown in Fig. 1 to Fig. 7 has.

As shown in Fig. 8A and Fig. 8B, the piezoelectric vibration sensor 100B has structure which includes the piezoelectric element 110, the element holding plate 120, the first support member 130a, the second support member 130b, a first vibration film 160a and a second vibration film 160b. Moreover, openings 161 are formed in the first vibration film 160a between the element holding plate 120 and the first support member 130a, and in the second vibration film 160b between the element support plate 120 and the second support member 130b. That is, the opening 161 is formed in the first vibration film 160a so as to be arranged between the element holding plate 120 and the first support member 130a. Similarly, another opening 161 is formed in the second vibration film 160b so as to be arranged between the element holding plate 120 and the second support member 130b.

Here, Fig. 8A and Fig. 8B are compared with Fig. 1A and Fig. 1B. The first vibration film 160a and the second vibration film 160b shown in Fig. 8B are different from the first vibration film 140a and the second vibration film 140b shown in Fig. 1B in a point that each of the first vibration film 160a and the second vibration film 160b has the opening 161.

Accordingly, in an area where the opening 161 is formed, cross-section secondary moment of the first vibration film 160a and the second vibration film 160b shown in Fig. 8A and Fig. 8B becomes not smaller than one of the first vibration film 140a and the second vibration film 140b shown in Fig. 1A and Fig. 1B. For this reason, in the case of the piezoelectric vibration sensor 100B, bend angles at a joint area of the first support member 130a and the first vibration film 160a, and a joint area of the second support member 130b and the second vibration film 160b become large, and an amount of bend at a central part of the element holding plate 120 become large in comparison with the piezoelectric vibration sensor 100. As a result, according to the piezoelectric vibration sensor 100B, it is possible to obtain the high sensitivity in comparison with the piezoelectric vibration sensor 100.

### [Third modification]

Next, a third modification 100C of the piezoelectric vibration sensor in the first exemplary embodiment of the present invention will be described on the basis of a drawing.

Fig. 9A and Fig. 9B are diagrams each of which shows structure of the piezoelectric vibration sensor 100C. Fig. 9A is a front view of the piezoelectric vibration sensor 100C, and Fig. 9B is a diagram which shows a view on arrow D of Fig. 9A and which is a top view of the piezoelectric vibration sensor 100C. Here, a component shown in Fig. 9A and Fig. 9B, which is equivalent to a component shown in Fig. 1 to Fig. 8, is assigned the same code as the component shown in Fig. 1 to Fig. 8 has.

As shown in Fig. 9A and Fig. 9B, the piezoelectric vibration sensor 100C has structure which includes the piezoelectric element 110, the element holding plate 120, the first support member 130a, the second support member 130b, a first vibration film 170a and a second vibration film 170b. Moreover, a plurality of openings 171 are formed in the first vibration film 170a between the element holding plate 120 and the first support member 130a, and in the second vibration film 170b between the element holding plate 120 and the second support member 130b. That is, a plurality of the openings 171 are formed in the first vibration film 170a so as to be arranged between the element holding plate 120 and the first support member 130a. Similarly, the other openings 161 are formed in the second vibration film 170b so as to be arranged between the element holding plate 120 and the second support member 130b.

Here, Fig. 9A and Fig. 9B are compared with Fig. 1A and Fig. 1B. The first vibration film 170a and the second vibration film 170b shown in Fig. 9B are different from the first vibration film 140a and the second vibration film 140b shown in Fig. 1B in a point that each of the first vibration film 170a and the second vibration film 170b has a plurality of the openings 171.

Accordingly, in an area where a plurality of the openings 171 are formed, cross-section secondary moment of the first vibration film 170a and the second vibration film 170b shown in Fig. 9A and Fig. 8B becomes not smaller than one of the first vibration film 140a and the second vibration film 140b shown in Fig. 1A and Fig. 1B. For this reason, in the case of the piezoelectric vibration sensor 100C, bend angles at a joint area of the first support member 130a and the first vibration film 170a, and a joint area of the second support member 130b and the second vibration film 170b become large, and an amount of bend at a central part of the element holding plate 120 become large in comparison with the piezoelectric vibration sensor 100. As a result, according to the piezoelectric vibration sensor 100C, it is possible to obtain the high sensitivity in comparison with the piezoelectric vibration sensor 100.

### [Fourth modification]

Next, a fourth modification 100D of the piezoelectric vibration sensor in the first exemplary embodiment of the present invention will be described on the basis of a drawing.

Fig. 10A and Fig. 10B are diagrams each of which shows structure of the piezoelectric vibration sensor 100D. Fig. 10A is a front view of the piezoelectric vibration sensor 100D. Fig. 10B is a diagram which shows a view on arrow E of Fig. 10A and which is a top view of the piezoelectric vibration sensor 100D. Here, a component shown in Fig. 10A and Fig. 10B, which is equivalent to a component shown in Fig. 1 to Fig. 9, is assigned the same code as the component shown in Fig 1 to Fig. 9 has.

As shown in Fig. 10A and Fig. 10B, the piezoelectric vibration sensor 100D has structure which includes the piezoelectric element 110, the element holding plate 120, the first support member 130a, the second support member 130b, a first vibration film 180a and a second vibration film 180b.

Here, Fig. 10A and Fig. 10B are compared with Fig. 1A and Fig. 1B. The first vibration film 180a and the second vibration film 180b shown in Fig. 10B are different from the first vibration film 140a and the second vibration film 140b, each of which has a form of rectangle as shown in Fig. 1B, in a point that each of the first vibration film 180a and the second vibration film 180 is in a form of trapezoid.

That is, the first vibration film 180a is set so that a width of the first vibration film 180a may become wide gradually as shifting from the first support member 130a toward the element holding plate 120 between the element holding plate 120 and the first support member 130a . Similarly, the second vibration film 180b is set so that a width of the second vibration film 180b may become wide gradually as shifting from the second support member 130b toward the element holding plate 120 between the element holding plate 120 and the second support member 130b.

As mentioned above, cross-section secondary moment becomes small as a width becomes narrow. Accordingly, cross-section secondary moment of the first support member 130a side of the first vibration film 180a, and the second support member 130b side of the second vibration film 180b shown in Fig. 10B becomes not smaller than one of the first vibration film 140a and the second vibration film 140b shown in Fig. 1B. For this reason, in the case of the piezoelectric vibration sensor 100D, bend angles at a joint area of the first support member 130a and the first vibration film 180a, and a joint area of the second support member 130b and the second vibration film 180b become large, and an amount of bend at a central part of the element holding plate 120 become large in comparison with the piezoelectric vibration sensor 100. As a result, according to the piezoelectric vibration sensor 100D, it is possible to obtain the high sensitivity in comparison with the piezoelectric vibration sensor 100.

### [Fifth modification]

Next, a fifth modification 100E of the piezoelectric vibration sensor in the first exemplary embodiment of the present invention will be described on the basis of a drawing.

Fig. 11A and Fig. 11B are diagrams each of which shows structure of the piezoelectric vibration sensor 100E. Fig. 11A is a front view of the piezoelectric vibration sensor 100E. Fig. 11B is a diagram which shows a view on arrow F of Fig. 11A and which is a top view of the piezoelectric vibration sensor 100E. Here, a component shown in Fig. 11A and Fig. 11B, which is equivalent to a component shown in Fig. 1 to Fig. 10, is assigned the same code as the component shown in Fig. 1 to Fig. 10 has.

As shown in Fig. 11A and Fig. 11B, the piezoelectric vibration sensor 100E has structure which includes the piezoelectric element 110, the element holding plate 120, the first support member 130a, the support member 130b, a first vibration film 190a and a second vibration film 190b.

Here, Fig. 11A and Fig. 11B are compared with Fig. 1A and Fig. 1B. The first vibration film 190a and the second vibration film 190b shown in Fig. 11B are different from the first vibration film 140a and the second vibration film 140b, which are in a form of rectangle as shown in Fig. 1B, in a point that the first vibration film 180a and the second vibration film 180 are in a form of trapezoid.

That is, the first vibration film 190a is set so that a width of the first vibration film 180a may become narrow gradually as shifting from the first support member 130a toward the element holding plate 120 between the element holding plate 120 and the first support member 130a. Similarly, the second vibration film 180b is set so that a width of the second vibration film 180b may become narrow gradually as shifting from the second support member 130b toward the element holding plate 120 between the element holding plate 120 and the second support member 130b.

As mentioned above, cross-section secondary moment becomes small as a width becomes narrow. Accordingly, cross-section secondary moment of the element holding plate 120 side of the first vibration film 190a and the second vibration film 190b shown in Fig. 11A and Fig. 11B becomes not smaller than one of the first vibration film 140a and the second vibration film 140b shown in Fig. 1A and Fig. 1B. For this reason, in the case of the piezoelectric vibration sensor 100D, bend angles at a joint area of the first support member 130a and the first vibration film 190a, and a joint area of the second support member 130b and the second vibration film 190b become large, and an amount of bend at a central part of the element holding plate 120 become large in comparison with the piezoelectric vibration sensor 100. As a result, according to the piezoelectric vibration sensor 100E, it is possible to obtain the high sensitivity in comparison with the piezoelectric vibration sensor 100.

Moreover, each of the first and the second vibration films 190a and 190b is set to have a wide width on the element holding plate 120 side between the element holding plate 120 and the second support member 130b in comparison with the second support member 130b side. In this case, the first support member 130a side of the first vibration film 190a has strong rigidity in comparison with the element holding plate 120 side of the first vibration film 190a. Similarly, the second support member 130b side of the second vibration film 190b has strong rigidity in comparison with the element holding plate 120 side of the second vibration film 190b. For this reason, according to the vibration sensor 100E, it is possible to restrain a twist of each of the first support member 130a side of the first vibration film 190a, and the second support member 130b side of the second vibration film 190b.

### <Second exemplary embodiment>

Next, structure of a piezoelectric vibration sensor 100F in a second exemplary embodiment of the present invention will be described on the basis of a drawing.

Fig. 12A and Fig. 12B are diagrams each of which shows the structure of the piezoelectric vibration sensor 100F. Fig. 12A is a front view of the piezoelectric vibration sensor 100F. Fig. 12B is a diagram which shows a view on arrow G of Fig. 12A and which is a top view of the piezoelectric vibration sensor 100F. Here, a component shown in Fig. 12A and Fig. 12B, which is equivalent to a component shown in Fig. 1 to Fig. 11, is assigned the same code as the component shown in Fig. 1 to Fig. 11 has.

As shown in Fig. 12A and Fig. 12B, the piezoelectric vibration sensor 100F has structure which includes the piezoelectric element 110, the element holding plate 120, the first support member 130a, the support member 130b and a vibration film 210.

Here, Fig. 12A and Fig. 12B are compared with Fig. 1A and Fig. 1B. As shown in Fig. 1A, the piezoelectric vibration sensor 100 has two vibration films (first vibration film 140a and second vibration film 140b). In contrast, the piezoelectric vibration sensor 100F has one vibration film 210. That is, as shown in Fig. 12A, a whole of a bottom plane of the element holding plate 120 is joined to a top plane of the vibration film 210. By virtue of the above, an effect which is the same as the effect which is explained in the first exemplary embodiment mentioned above is provided. Moreover, according to the piezoelectric vibration sensor 100F, since number of the vibration films 210 is one, it is possible to reduce number of parts and to assemble the piezoelectric vibration sensor 100F with ease in comparison with the piezoelectric vibration sensor 100F.

### <Third exemplary embodiment>

Next, structure of a piezoelectric vibration sensor 100G in a third exemplary embodiment of the present invention will be described on the basis of a drawing.

Fig. 13A, Fig. 13B and Fig. 13C are diagrams each of which shows the structure of the piezoelectric vibration sensor 100G. Fig. 13A is a front view of the piezoelectric vibration sensor 100G. Fig. 13B is a diagram which shows a view on arrow H of Fig. 13A and which is a top view of the piezoelectric vibration sensor 100G. Fig. 13C is a diagram which shows a view on arrow I of Fig. 13A and which is a side view of the piezoelectric vibration sensor 100G. Here, a component shown in Figs. 13A to C, which is equivalent to a component shown in Fig. 1 to Fig. 12, is assigned the same code as the component shown in Fig. 1 to Fig. 12 has.

As shown in Fig. 13A, Fig. 13B and Fig. 13C, the piezoelectric vibration sensor 100G has structure which includes the piezoelectric element 110, the element holding plate 120, the first support member 130a, the second support member 130b, a first vibration film 220a and a second vibration film 220b.

Here, Fig. 13A, Fig. 13B and Fig. 13C are compared with Fig. 1A and Fig. 1B. As shown in Fig. 1A and Fig. 1B, in the case of the piezoelectric vibration sensor 100, each top plane of the first support member 130a and the second support member 130b is not opposite to the bottom plane of the element holding plate 120. Moreover, an end part of the element holding plate 120, and the first support member 130a are connected each other through the first vibration film 140a in a direction that the first vibration film 140a extends (in a right and left direction on a paper of Fig. 1A). Similarly, another end part of the element holding plate 120, and the second support member 130b are connected each other through the second vibration film 140b in the direction that the second vibration film 140b extends (in a right and left direction on the paper of Fig. 1 A).

In contrast, as shown in Fig. 13A, Fig. 13B and Fig. 13C, in the case of the piezoelectric vibration sensor 100G, each top plane of the first support member 130a and the second support member 130b is opposite to the bottom plane of the element holding plate 120. Moreover, the first vibration film 220a is interposed between the bottom plane of the element holding plate 120 and the top plane of the first support member 130a. Similarly, the second vibration film 220b is interposed between the bottom plane of the element holding plate 120 and the top plane of the second support member 130b. Here, the first vibration film 220a and the second vibration film 220b are arranged so as to extend in a direction of one plane of the element holding plate 120 (in a right and left direction on a paper of Fig. 13A)

As mentioned above, in the case of the piezoelectric vibration sensor 100G according to the third exemplary embodiment of the present invention, the first vibration film 220a is interposed between the element holding plate 120 and the first support member 130a. The second vibration film 220b is interposed between the element holding plate 120 and the second support member 130b.

As a result, the exemplary embodiment provides not only an effect to make the piezoelectric vibration sensor 100G have a small size, but also an effect which is the same as the effect of the first exemplary embodiment.

### [First modification]

Next, structure of a first modification 100H of the piezoelectric vibration sensor 100G in the third exemplary embodiment of the present invention will be described on the basis of a drawing.

Fig. 14A, Fig. 14B and Fig. 14C are diagrams each of which shows the structure of the piezoelectric vibration sensor 100H. Fig. 14A is a front view of the piezoelectric vibration sensor 100G. Fig. 14B is a diagram which shows a view on arrow J of Fig. 14A and which is a top view of the piezoelectric vibration sensor 100H. Fig. 14C is a diagram which shows a view on arrow K of Fig. 14A and which is a side view of the piezoelectric vibration sensor 100H. Here, a component shown in Fig. 14A, Fig. 14B and Fig. 14C, which is equivalent to a component shown in Fig. 1 to Fig. 13, is assigned the same code as the component shown in Fig. 1 to Fig. 13 has.

As shown in Fig. 14A, Fig. 14B and Fig. 14C, the piezoelectric vibration sensor 100H has structure which includes the piezoelectric element 110, the element holding plate 120, the first support member 130a, the support member 130b, a first vibration film 230a and a second vibration film 230b.

Here, Figs. 14A to C are compared with Figs. 13A to C. As shown in Fig. 13A, Fig. 13B and Fig. 13C, in the case of the piezoelectric vibration sensor 100G, each top plane of the first support member 130a and the second support member 130b is opposite to the bottom plane of the element holding plate 120. Similarly, as shown in Fig. 14A, Fig. 14B and Fig. 14C, in the case of the piezoelectric vibration sensor 100H, each top plane of the first support member 130a and the second support member 130b is opposite to the bottom plane of the element holding plate 120. Both are coincident in this point.

As shown in Fig. 13A, Fig. 13B and Fig. 13C, in the case of the piezoelectric vibration sensor 100G, the first vibration film 220a and the second vibration film 220b are arranged so as to extend in the direction of one plane of the element holding plate 120 (in the right and left direction on the paper of Fig. 13A)

In contrast, as shown in Fig. 14A, Fig. 14B and Fig. 14C, in the case of the piezoelectric vibration sensor 100H, the first vibration film 230a and the second vibration film 230b are arranged so as to extend in a direction of thickness of the element holding plate 120 (in an up and down direction on a paper of Fig. 14A) Both are different in this point.

More specifically, each top plane of the first support member 130a and the second support member 130b are arranged apart so as to be opposite each other. Moreover, the first vibration film 230a is arranged between the top plane of the first support member 130a and the bottom plane of the element holding plate 120 so as to connect the first support member 130a and the element holding plate 120. Similarly, the second vibration film 230b is arranged between the top plane of the second support member 130b and the bottom plane of the element holding plate 120 so as to connect the second support member 130b and the element holding plate 120. As shown in Fig. 14A, the first vibration film 230a and the second vibration film 230b are extended upward from the first support member 130a and the second support member 130b respectively toward a central part of the element holding plate 120. By virtue of the above-mentioned structure, it is possible to prevent the element holding plate 120 from shifting in a right or left direction on a paper of Fig. 14A.

As mentioned above, in the case of the first modification 100H of the piezoelectric vibration sensor in the third exemplary embodiment of the present invention, the vibration film (first vibration film 230a and second vibration film 230b) extends in the direction of thickness of the element holding plate 120. Also by the structure, an effect which is the same as the effect described in the third exemplary embodiment is provided.

### [Second modification]

Next, a second modification 100I of the piezoelectric vibration sensor in the third exemplary embodiment of the present invention will be described on the basis of a drawing.

Fig. 15A, Fig. 15B and Fig. 15C are diagrams each of which shows structure of the piezoelectric vibration sensor 100I. Fig. 15A is a front view of the piezoelectric vibration sensor 100I. Fig. 15B is a diagram which shows a view on arrow L of Fig. 15A and which is a top view of the piezoelectric vibration sensor 100I. Fig. 15C is a diagram which shows a view on arrow M of Fig. 15A and which is a side view of the piezoelectric vibration sensor 100I. Here, a component shown in Figs. 15A to C, which is equivalent to a component shown in Fig. 1 to Fig. 14 is, assigned the same code as the component shown in Fig. 1 to Fig. 14 has.

As shown in Fig. 15A, Fig. 15B and Fig. 15C, the piezoelectric vibration sensor 100I has structure which includes the piezoelectric element 110, the element holding plate 120, the first support member 130a, the second support member 130b, a first vibration film 240a and a second vibration film 240b.

Here, Figs 15A to C are compared with Figs 14A to C. As shown in Fig. 14A, Fig. 14B and Fig. 14C, in the case of the piezoelectric vibration sensor 100H, the first vibration film 230a and the second vibration film 230b are arranged so as to extend in the direction of thickness of the element holding plate 120 (in the up and down direction on the paper of Fig. 14A) Similarly, as shown in Fig. 15A, Fig. 15B and Fig. 15C, in the case of the piezoelectric vibration sensor 100I, the first vibration film 240a and the second vibration film 240b are arranged so as to extend in the direction of thickness of the element holding plate 120 (in an up and down direction on a paper of Fig. 15A) Both are coincident in this point.

Moreover, according to Fig. 15A, the first vibration film 240a is arranged between the element holding plate 120 and the first support member 130a so as to be curved. Similarly, the second vibration film 240b is arranged between the element holding plate 120 and the second support member 130b so as to be curved. In contrast, according to Fig. 14A, the first vibration film 230a is not curved between the element holding plate 120 and the first support member 130a, and the second vibration film 230b is not curved between the element holding plate 120 and the second support member 130b. Both are different in this point.

More specifically, each top plane of the first support member 130a and the second support member 130b is arranged apart from the element holding plate 120 so as to be opposite to the bottom plane of the element holding plate 120. Moreover, the first vibration film 240a is arranged between the top plane of the first support member 130a and the bottom plane of the element holding plate 120 so as to connect the first support member 130a and the element holding plate 120. Similarly, the second vibration film 240b is arranged between the top plane of the second support member 130b and the bottom plane of the element holding plate 120 so as to connect the second support member 130b and the element holding plate 120. As shown in Fig. 15A, the first vibration film 240a is arranged between the top plane of the first support member 130a and the bottom plane of the element holding plate 120 so as to be curved in a form like the alphabetic character 'U' lies, and the second vibration film 240b is arranged between the top plane of the second support member 130b and the bottom plane of the element holding plate 120 so as to be curved in a form like the alphabetic character 'U' which is laid. By virtue of the above-mentioned structure, an effect which is the same as the effect described in the third exemplary embodiment is provided. Moreover, by intervention of the curved first vibration film 240a and the curved second vibration film 240b, the first support member 130a and the second support member 130b can support the element holding plate 120 with stability.

### [Example]

Next, an example of the electronic equipment 1000, which includes the piezoelectric vibration sensor 100 in the first exemplary embodiment of the present invention, will be described as an example 1-1 to an example 1-8. Similarly, an example of an electronic equipment, which includes the piezoelectric vibration sensor 100G in the third exemplary embodiment of the present invention, will be described as an example 2. Moreover, an example of the related piezoelectric vibration sensor 900 (refer to Fig. 5) will be described as a related example.

Fig. 16 is a diagram for explaining a size relation of the example of the piezoelectric vibration sensor 100. Fig. 17 is a diagram for explaining a size relation of the example of the piezoelectric vibration sensor 100G. Fig. 18 is a diagram showing an evaluation result on the examples of the piezoelectric vibration sensor 100 and the piezoelectric vibration sensor 100G.

### [Member]

Firstly, each member of the piezoelectric vibration sensor 100 and the piezoelectric vibration sensor 100G will be described.

### [Base member 111]

As material of the base member 111, piezoelectric ceramic material which contains lead titanium zirconate is used. It is assumed that a size of the base member 111 is 4 mm in length, 3 mm in width and 0.5 mm in thickness. Here, the length indicates magnitude in a right and left direction on a paper of Fig. 1A. The width indicates magnitude in a direction vertical to a paper of Fig. 1B. Similarly, the width indicates magnitude in an up and down direction on the paper of Fig. 1B. The thickness indicates magnitude in an up and down direction on the paper of Fig. 1A. Hereinafter, it is assumed that definition on a length, a width and a thickness of another member is based on the above-mentioned definition.

### [Electrode 112]

It is assumed that material of the electrode 112 is silver.

### [Piezoelectric element 110]

The piezoelectric element 110 is made by forming silver electrodes on both planes of the base member 111, which is made of the piezoelectric ceramic material, as the electrode 112.

### [Element holding plate 120]

42 alloy is used as material of the element holding plate 120.

### [Vibrator 300]

By joining one main plane of the piezoelectric element 110 to one plane of the element holding plate 120, the vibrator 300 is formed. That is, the vibrator 300 is a joint member, which includes the piezoelectric element 110 and the element holding plate 120, in this description.

### [First support member 130a and second support member 130b]

ABS resin is used as material of the first support member 130a and the second support member 130b. It is assumed that a size of the support member is 1 mm in length, 3 mm in width and 0.5 mm in thickness.

### [First vibration films 140a and 220a, and second vibration films 140b and 220b]

PET is used as material of the first vibration films 140a and 220a and the second vibration films 140b and 220b.

Here, as shown in Fig. 16, a size related to the first vibration film 140a and the second vibration film 140b of the piezoelectric vibration sensor 100 is specified by a thickness t2 and a length L2 between the second support member 130b and the joint area. The thickness t2 of the second vibration film 140b is determined by a ratio between the thickness t2 and a thickness t1 of the second support member 130b. Moreover, the length L2 of the second vibration film 140b between a joint area of the second vibration film 140b and the second support member 130b, and an edge side of the second vibration film 140b which is near to the central part of the element holding plate 120 is determined by a ratio between the length L2 and a length L1 between the edge side of the second vibration film 140b which is near to the central part of the element holding plate 120, and an edge side of the piezoelectric element 110.

Similarly, as shown in Fig. 17, a size related to the first vibration film 220a and the second vibration film 220b of the piezoelectric vibration sensor 100G is specified by the thickness t2.

### [Housing 400]

It is assumed that material of the housing is stainless steel (SUS).

### [Manufacturing method]

A method of manufacturing the example of the electronic equipment 1000, which includes the piezoelectric vibration sensor 100, will be described in the following.

As shown in Fig. 1A and Fig. 1B, by joining one main plane of the piezoelectric element 110, which has been prepared as mentioned above, to one plane of the element holding plate 120, the vibrator 300 is formed. The first vibration film 140a and the second vibration film 140b are joined to one end part and the other end part of the element holding plate 120 respectively. As shown in Fig. 1A and Fig. 1B, the bottom plane of the end part of the first vibration film 140a is joined to the top plane of the first support member 130a, and the bottom plane of the end part of the second vibration film 140b is joined to the top plane of the second support member 130b As a result, the piezoelectric vibration sensor 100 has been manufactured completely. Then, the manufactured piezoelectric vibration sensor 100 is joined to the housing 400.

Next, a method of manufacturing the example of the electronic equipment including the piezoelectric vibration sensor 100G will be described.

Similarly to the piezoelectric vibration sensor 100 mentioned above, by joining one main plane of the piezoelectric element 110, which has been prepared, to one plate of the element holding plate 120, the vibrator 300 is formed. Each member is joined each other so that the first vibration film 220a may be interposed between one end part of the element holding member 120 and the first support member 130a, and the second vibration film 220b may be interposed between the other end part of the element holding member 120 and the second support member 130b. As a result, the piezoelectric vibration sensor 100G has been manufactured completely. Then, the manufactured piezoelectric vibration sensor 100G is joined to the housing 400.

### [Evaluation method]

Next, an evaluation method of the piezoelectric vibration sensor 100 will be described. It is assumed that evaluation items are 'normalized sensitivity (10Hz)', 'degree of flatness of sensor sensitivity frequency characteristic' and 'durability against drop impact'.

The piezoelectric vibration sensor 100 and the piezoelectric vibration sensor 100G, each of which is a measurement object, use components which use each member mentioned above.

Here, the lengths of L1 and L2 shown in Fig. 16 are set by the ratio between L1 and L2. Similarly, the thickness of t1 and t2 shown in Fig. 16 and Fig. 17 are set by the ratio between t1 and t2.

### [Normalized sensitivity (10Hz)]

Sine wave type alternating vibration, whose frequency is 10Hz and whose acceleration vibration is 0.1 m/s², is added vertically to a main plane of each vibrator 300 of the piezoelectric vibration sensor 100 and the piezoelectric vibration sensor 100G as a detection target signal, and then a voltage which the sensor outputs at this time is measured. Then, a measurement result on the sensor sensitivity of the related piezoelectric vibration sensor 900 (refer to Fig. 5) is normalized to 1, and the normalized sensor sensitivity is defined as normalized sensitivity (10Hz). It can be conceived that the sensitivity becomes high as a value of the normalized sensitivity (10Hz) is large.

### [Degree of flatness of sensor sensitivity frequency characteristic]

As an index of flatness of sensitivity frequency characteristic of the piezoelectric vibration sensors 100, 100G and 900, a degree of flatness of sensor sensitivity frequency characteristic is calculated. Here, a degree of flatness of sensor sensitivity frequency characteristic is calculated on the basis of a ratio between the normalized sensitivity (10Hz) and the sensor sensitivity at the mechanical resonant frequency. The mechanical resonant frequency is measured by a vibration generator's applying broadband frequency vibration to each of the piezoelectric vibration sensors 100, 100G and 900, and by a laser Doppler vibration meter's measuring vibration amplitude frequency characteristic of a bending movement to which the vibrator 300 is excited. Then, the sensor sensitivity which is obtained by measuring the related piezoelectric vibration sensor 900 (refer to Fig. 5) is normalized to 1, and the normalized sensor sensitivity is defined as a degree of flatness of sensor sensitivity frequency characteristic. It can be conceived that the sensor sensitivity frequency characteristic is flat as a degree of flatness of sensor sensitivity frequency characteristic becomes small. That is, if a degree of flatness of sensor sensitivity frequency characteristic is small, it is possible to obtain constant sensitivity over a wide frequency range, for example, like a characteristic curve of the piezoelectric vibration sensor 100 according to the present invention shown in Fig. 6. On the other hand, if a degree of flatness of sensor sensitivity frequency characteristic is large, it is possible to obtain high sensitivity only in a narrow frequency range, for example, like a characteristic curve of the general piezoelectric vibration sensor 900 shown in Fig. 6.

### [Durability against drop impact]

Next, in order to evaluate the durability against drop impact of the piezoelectric vibration sensors 100, 100G and 900, each of the produced piezoelectric vibration sensors 100, 100G and 900 is stored in the housing 400 (in this case, a case of cellular phone is used), and the sensor sensitivity at 100Hz is measured after 10 times drop tests from a height of 150cm. Then, results on the sensor sensitivity before and after applying the drop impact are compared. At this time, it is assumed that, if a difference between the sensor sensitivity before applying the drop impact and the sensor sensitivity after applying the drop impact is within 3.0 dB, an evaluation result is 'Good'. On the other hand, if the difference is not smaller than 3.0 dB, or if a fault is caused, the evaluation result is 'Bad'.

### [Evaluation result]

Each of rows of examples 1-1 to 1-8 in Fig. 18 indicates an evaluation result of the piezoelectric vibration sensor 100 according to the present invention. Moreover, a row of example 2 in Fig. 18 indicates an evaluation result of the piezoelectric vibration sensor 100G according to the present invention. Moreover, a row of related example in Fig. 18 indicates an evaluation result of the related piezoelectric vibration sensor 900 (refer to Fig. 5)

### [Normalized sensitivity (10Hz)]

On the assumption that a result of the related example is normalized to 1, results of the examples 1-1 to 1-8 and the example 2 on the normalized sensitivity (10Hz) are indicated. The examples 1-1 to 1-8 and the example 2 are compared with the related example on the basis of the result shown in Fig. 18. As shown in Fig. 18, each result of the examples 1-1 to 1-8 and the example 2 shows that sufficiently high sensitivity is obtained in comparison with the result of the related example.

### [Degree of flatness of sensor sensitivity frequency characteristic]

On the assumption that a result of the related example is normalized to 1, results of the examples 1-1 to 1-8 and the example 2 on a degree of flatness of sensor sensitivity frequency characteristic are indicated. The examples 1-1 to 1-8 and the example 2 are compared with the related example on the basis of the result shown in Fig. 18. As shown in Fig. 18, each result of the examples 1-1 to 1-8 and the example 2 shows that sufficiently low degree of flatness is obtained in comparison with the result of the related example. Here, Fig. 18 also shows the normalized resonant frequency. The normalized resonant frequency is a resonant frequency of each of the examples 1-1 to 1-8 and the example 2 on the assumption that the mechanical resonant frequency of the general piezoelectric vibration sensor 900 is normalized to 1.

### [Durability against drop impact]

By evaluating a difference between the sensitivity before applying the drop impact and the sensitivity after applying the drop impact on the basis of the above-mentioned evaluation criterion with using marks 'Good' and 'Bad', the durability against drop impact is evaluated. As shown in Fig. 18, while a fault is caused in the case of the related example, the evaluation result 'Good' is obtained in every case of the examples 1-1 to 1-8 and the example 2.

### [Summary]

As shown in Fig. 18 mentioned above, in every case of the examples 1-1 to 1-8 and the example 2 which are set according to a plurality of combinations of L1/L2 and t1/t2, the high sensitivity, the flat frequency characteristic and the strong durability against drop impact are obtained in comparison with the related example (related piezoelectric vibration sensor 900). It is confirmed that, since the art according to the present invention is applicable to a wide range of L1, L2, t1 and t2 as mentioned above, the art is preferable for miniaturizing the piezoelectric vibration sensor.

While the invention has been particularly shown and described with reference to exemplary embodiments thereof, the invention is not limited to these embodiments. It will be understood by those of ordinary skill in the art that various changes in form and details may be made therein without departing from the spirit and scope of the present invention as defined by the claims.

The whole or part of the first to third exemplary embodiments disclosed above can be described as, but not limited to, the following supplementary notes.
[Supplementary note 1] A piezoelectric vibration sensor, comprising:
   a piezoelectric element on whose at least one plane an electrode is arranged and which is in a form of flat plane;
   an element holding plate to whose one plate the piezoelectric element is joined and which is in a form of flat plane;
   a first support member and a second support member which support the piezoelectric element and the element holding plate; and
   a vibration film which activates vibration of the element holding plate between the first support member and the second support member, wherein
   the element holding plate is joined to each of the first support member and the second support member through the vibration film.
[Supplementary note 2] The piezoelectric vibration sensor according to addition 1, wherein
   the vibration film includes:
   a first vibration film which joins the element holding plate and the first support member together; and
   a second vibration film which joins the element holding plate and the second support member together.
[Supplementary note 3] The piezoelectric vibration sensor according to addition 1 or 2, comprising:
   openings which are formed in the first vibration film and the second vibration film between the element holding plate and the support member.
[Supplementary note 4] The piezoelectric vibration sensor according to any one of additions 1 to 3, wherein
   a width of the first vibration film is set so as to become wide gradually as shifting from the first support member toward the element holding plate between the element holding plate and the first support member, and wherein
   a width of the second vibration film is set so as to become wide gradually as shifting from the second support member toward the element holding plate between the element holding plate and the second support member.
[Supplementary note 5] The piezoelectric vibration sensor according to any one of additions 1 to 3, wherein
   a width of the first vibration film is set so as to become narrow gradually as shifting from the first support member toward the element holding plate between the element holding plate and the first support member, and wherein
   a width of the second vibration film is set so as to become narrow gradually as shifting from the second support member toward the element holding plate between the element holding plate and the second support member.
[Supplementary note 6] The piezoelectric vibration sensor according to any one of additions 1 to 5, wherein
   the vibration film extends in a direction of the one plane of the element holding plate.
[Supplementary note 7] The piezoelectric vibration sensor according to addition 6, wherein
   the vibration films are interposed between the element holding plate and the first support member and between the element holding plate and the second support member.
[Supplementary note 8] The piezoelectric vibration sensor according to any one of additions 1 to 5, wherein
   the vibration film extends in a direction of thickness of the element holding plate.
[Supplementary note 9] The piezoelectric vibration sensor according to addition 8, wherein
   the vibration film is arranged between the element holding plate and the support member so as to be curved.
[Supplementary note 10] The piezoelectric vibration sensor according to any one of additions 1 to 9, wherein
   the vibration film is made of polyethylene terephthalate.
[Supplementary note 11] The piezoelectric vibration sensor according to any one of additions 1 to 10, wherein
   the piezoelectric elements are joined to both the one plane of the element holding plate and another plane of the element holding plate which is opposite to the one plane.
[Supplementary note 12] An electronic equipment, comprising:
   the piezoelectric vibration sensor which is described in any one of additions 1 to 11.

With the above mention, the present invention has been described based on the exemplary embodiment. The exemplary embodiment is an exemplification, and various changes, additions or deletions, and combinations may be added to each exemplary embodiment as far as not departing from the scope of the present invention. It can be understood by a person skilled in the art that a modification, to which the change, the addition or deletion, and the combination are added, exists in the scope of the present invention.

This application is based upon and claims the benefit of priority from Japanese Patent Application No. 2012-84670, filed on April 3, 2010, the disclosure of which is incorporated herein in its entirety by reference.

### [Industrial Applicability]

The piezoelectric vibration sensor according to the present invention is installed in an electronic equipment, which is small and excellent in portability, such as a cellular phone, a laptop personal computer, PDA or the like.

### [Reference signs List]

- 100: piezoelectric vibration sensor
- 100A: piezoelectric vibration sensor
- 100B: piezoelectric vibration sensor
- 100C: piezoelectric vibration sensor
- 100D: piezoelectric vibration sensor
- 100E: piezoelectric vibration sensor
- 100F: piezoelectric vibration sensor
- 100G: piezoelectric vibration sensor
- 100H: piezoelectric vibration sensor
- 110: piezoelectric element
- 111: base member
- 112: electrode
- 120: element holding plate
- 130a: first support member
- 130b: second support member
- 140a: first vibration film
- 140b: second vibration film
- 150a: first vibration film
- 150b: second vibration film
- 160a: first vibration film
- 160b: second vibration film
- 170a: first vibration film
- 170b: second vibration film
- 180a: first vibration film
- 180b: second vibration film
- 190a: first vibration film
- 190b: second vibration film
- 220a: first vibration film
- 220b: second vibration film
- 230a: first vibration film
- 230b: second vibration film
- 240a: first vibration film
- 240b: second vibration film
- 300: vibrator
- 400: housing
- 900: piezoelectric vibration sensor
- 1000: electronic equipment

## Claims

1. A piezoelectric vibration sensor, comprising:
a piezoelectric element on whose at least one plane an electrode is arranged and which is in a form of flat plane;
an element holding plate to whose one plate the piezoelectric element is joined and which is in a form of flat plane;
a first support member and a second support member which support the piezoelectric element and the element holding plate; and
a vibration film which activates vibration of the element holding plate between the first support member and the second support member, wherein
the element holding plate is joined to each of the first support member and the second support member through the vibration film.

2. The piezoelectric vibration sensor according to claim 1, wherein
the vibration film, comprising:
a first vibration film which joins the element holding plate and the first support member together; and
a second vibration film which joins the element holding plate and the second support member together.

3. The piezoelectric vibration sensor according to claim 1 or 2, comprising:
openings which are formed in the first vibration film and the second vibration film between the element holding plate and the support member.

4. The piezoelectric vibration sensor according to any one of claims 1 to 3, wherein
a width of the first vibration film is set so as to become wide gradually as shifting from the first support member toward the element holding plate between the element holding plate and the first support member, and wherein
a width of the second vibration film is set so as to become wide gradually as shifting from the second support member toward the element holding plate between the element holding plate and the second support member.

5. The piezoelectric vibration sensor according to any one of claims 1 to 3, wherein
a width of the first vibration film is set so as to become narrow gradually as shifting from the first support member toward the element holding plate between the element holding plate and the first support member, and wherein
a width of the second vibration film is set so as to become narrow gradually as shifting from the second support member toward the element holding plate between the element holding plate and the second support member.

6. The piezoelectric vibration sensor according to any one of claims 1 to 5, wherein
the vibration film extends in a direction of the one plane of the element holding plate.

7. The piezoelectric vibration sensor according to claim 6, wherein
the vibration films are interposed between the element holding plate and the first support member and between the element holding plate and the second support member.

8. The piezoelectric vibration sensor according to any one of claims 1 to 5, wherein
the vibration film extends in a direction of thickness of the element holding plate.

9. The piezoelectric vibration sensor according to claim 8,
wherein
the vibration film is arranged between the element holding plate and the support member so as to be curved.

10. An electronic equipment, comprising:
the piezoelectric vibration sensor according to any one of claims 1 to 9.
